# EUROPEAN PATENT SPECIFICATION

(11) **EP 3 306 375 B1**
(45) Date of publication and mention of the grant of the patent: **27.03.2019**
(21) Application number: 17171889.3
(22) Date of filing: 19.05.2017
(51) Int. Cl.: G02B 27/10, G03B 21/20, H01S 5/40, G02B 19/00

(54) **AN APPARATUS FOR COMBINING LIGHT BEAMS**
VORRICHTUNG ZUM KOMBINIEREN VON LICHTSTRAHLEN
APPAREIL DE COMBINAISON DE FAISCEAUX DE LUMIÈRE

(30) Priority: 07.10.2016 US 201615288165
(43) Date of publication of application: 11.04.2018
(73) Proprietor: Christie Digital Systems USA, Inc., Cypress, CA 90630 (US)
(72) Inventor: ADEMA, Daniel Robert, Kitchener, Ontario N2P 1T5 (CA)
(74) Representative: Wynne-Jones IP Limited

(56) References cited:
- WO-A2-2006/027621
- CN-B- 102 904 161
- CN-U- 201 886 268
- US-A1- 2015 267 878

## Description

### FIELD

The present specification relates to an apparatus for combining light beams, and in particular to an apparatus for combining light beams using a curved reflector.

### BACKGROUND

Laser light sources are used in image projection because of their narrow emission spectrum, among other characteristics. Laser light can be generated by a variety of different light sources, including solid-sated light sources such as laser diodes. In image projection applications, often laser beams from a large number of laser diodes need to be brought together to form a combined beam that is then used for image projection. Traditionally, vast arrays of small fold mirrors have been used to bring such large numbers of laser beams together. Fabricating and aligning these arrays of fold mirrors can be challenging. Moreover, such fold mirrors cannot easily accommodate an increase in the number of light sources without the need to build and/or add additional fold mirrors.

WO2006027621 A2 discloses a light engine for use in projection display systems.

### SUMMARY

In this specification, elements may be described as "configured to" perform one or more functions or "configured for" such functions. In general, an element that is configured to perform or configured for performing a function is enabled to perform the function, or is suitable for performing the function, or is adapted to perform the function, or is operable to perform the function, or is otherwise capable of performing the function.

It is understood that for the purpose of this specification, language of "at least one of X, Y, and Z" and "one or more of X, Y and Z" can be construed as X only, Y only, Z only, or any combination of two or more items X, Y, and Z (e.g., XYZ, XY, YZ, ZZ, and the like). Similar logic can be applied for two or more items in any occurrence of "at least one ..." and "one or more..." language.

An aspect of the present specification provides an apparatus for combining light, the apparatus comprising: a support having a first face and a second face opposite the first face, the support defining a support aperture extending through the first face and the second face; a first receiving bank disposed on the first face, the first receiving bank configured to receive a first set of light sources configured to emit a first set of light beams; and a second receiving bank disposed on the second face, the second receiving bank configured to receive a second set of light sources configured to emit a second set of light beams. The apparatus also comprises a first reflector disposed to a side of the support opposite the second face, the first reflector facing the first face, the first reflector configured to reflect the first set of light beams towards the support aperture and to increase a convergence of the first set of light beams, the first reflector defining a reflector aperture; a second reflector disposed to another side of the support opposite the first face, the second reflector facing the second face, the second reflector configured to reflect the second set of light beams towards the support aperture and to increase a corresponding convergence of the second set of light beams; and a differential reflector disposed in the support aperture, the differential reflector configured to reflect the first set of light beams in a direction away from the second reflector and to transmit the second set of light beams in a corresponding direction away from the second reflector.

The support can comprise a circular disk and the support aperture can be disposed at a center of the circular disk.

The apparatus can further comprise a plurality of additional first receiving banks each configured to receive a corresponding set of light sources and a plurality of additional second receiving banks each configured to receive a corresponding set of light sources, the first receiving bank and the plurality of additional first receiving banks disposed radially on the first face, and the second receiving bank and the plurality of additional second receiving banks disposed radially on the second face.

The support can comprise a cold plate.

The apparatus can further comprise the first set of light sources received in the first receiving bank and the second set of light sources received in the second receiving bank.

The first reflector can comprise a first curvature configured to increase the convergence of the first set of light beams; and/or the second reflector can comprise a second curvature configured to increase the corresponding convergence of the second set of light beams.

One or more of the first reflector and the second reflector can comprise a parabolic reflector.

One or more of the first reflector and the second reflector can comprise one or more of a stepped reflector and a faceted reflector.

The first set of light beams can have a first wavelength range and the second set of light beams can have a second wavelength range different from the first wavelength range; and the differential reflector can comprise a dichroic reflector configured to at least partially reflect the first set of light beams and to at least partially transmit the second set of light beams.

The differential reflector can comprise a reflective region configured to reflect the first set of light beams and a transmissive region configured to transmit the second set of light beams.

The reflective region and the transmissive region can be shaped as concentric rings.

The apparatus can further comprise a diffuser disposed to the side of the support opposite the second face, the diffuser configured to form a diffused light by intercepting and at least partially transmitting the first set of light beams reflected from the differential reflector and the second set of light beams transmitted through the differential reflector.

The apparatus can further comprise a first lens disposed proximate the diffuser and to a corresponding side of the diffuser opposite the support, the first lens comprising a first lens face configured to receive at least a portion of the diffused light and a second lens face opposite the first lens face, the first lens configured to reduce a divergence of the portion of the diffused light and to form an output light propagating towards the reflector aperture.

The apparatus can further comprise an integrating rod having an end disposed proximate the first face, the end positioned to receive the first set of light beams reflected from the differential reflector and the second set of light beams transmitted through the differential reflector.

The second reflector can comprise a beam splitter configured to reflect a first portion of the second set of light beams towards the support aperture and to transmit a second portion of the second set of light beams; and the apparatus can further comprise a third reflector disposed to a corresponding side of the second reflector opposite the support, the third reflector facing the second face, the third reflector configured to reflect the second portion towards the support aperture and to increase a corresponding convergence of the second portion.

The apparatus can further comprise: a beam splitter positioned to intercept the second set of light beams propagating from the second reflector towards the support aperture, the beam splitter configured to reflect a first portion of the second set of light beams and to transmit a second portion of the second set of light beams; and a fourth reflector disposed to a corresponding side of the beam splitter opposite the support, the fourth reflector facing the second face, the fourth reflector configured to reflect the first portion towards the support aperture.

The first receiving bank can be disposed on a plane inclined relative to the first face; and/or the second receiving bank can be disposed on a corresponding plane inclined relative to the second face.

According to another aspect of the present specification there is provided an apparatus for combining light, the apparatus comprising: a first light collecting unit comprising: a first support having a first face and a second face opposite the first face, the first support defining a first support aperture extending through the first face and the second face; a first receiving bank disposed on the second face, the first receiving bank configured to receive a first set of light sources configured to emit a first set of light beams of a first color; and a first reflector disposed proximate the second face and facing the second face, the first reflector configured to reflect the first set of light beams and to increase a convergence of the first set of light beams, the first reflector defining a first reflector aperture. The apparatus also comprises a second light collecting unit comprising: a second support having a third face and a fourth face opposite the third face, the second support defining a second support aperture extending through the third face and the fourth face, the second support disposed side-by-side with the first support such that the second face faces the third face and the first reflector is disposed between the first support and the second support; a second receiving bank disposed on the fourth face, the second receiving bank configured to receive a second set of light sources configured to emit a second set of light beams of a second color; and a second reflector disposed proximate the fourth face and facing the fourth face, the second reflector configured to reflect the second set of light beams and to increase a corresponding convergence of the second set of light beams, the second reflector defining a second reflector aperture. The apparatus also comprises a third light collecting unit comprising: a third support having a fifth face and a sixth face opposite the fifth face, the third support defining a third support aperture extending through the fifth face and the sixth face, the third support disposed side-by-side with the second support such that the fourth face faces the fifth face and the second reflector is disposed between the second support and the third support; a third receiving bank disposed on the sixth face, the third receiving bank configured to receive a third set of light sources configured to emit a third set of light beams of a third color; and a third reflector disposed proximate the sixth face and facing the sixth face, the third reflector configured to reflect the third set of light beams and to increase a corresponding convergence of the third set of light beams. In addition, the apparatus also comprises a fourth reflector configured to reflect the first set of light beams propagating from the first reflector onto a first differential reflector, the first differential reflector configured to reflect the first set of light beams towards a light collection area; and a fifth reflector configured to reflect the second set of light beams propagating from the second reflector onto a second differential reflector, the second differential reflector configured to reflect the second set of light beams towards a first relay optics configured to direct the second set of light beams through the second support aperture, through the first reflector aperture, and towards the first differential reflector and the light collection area, the first differential reflector further configured to transmit the second set of light beams. Furthermore, the apparatus also comprises a second relay optics configured to direct the third set of light beams propagating from the third reflector through the third support aperture, through the second reflector aperture, and towards the second differential reflector, the second differential reflector further configured to transmit the third set of light beams towards the first relay optics, the first relay optics further configured to direct the third set of light beams through the second support aperture, the first reflector aperture, and towards the first differential reflector and the light collection area, the first differential reflector further configured to transmit the third set of light beams.

The apparatus can further comprise a sixth reflector and a seventh reflector, the sixth reflector positioned to intercept the third set of light beams propagating from the third reflector towards the second relay optics, the sixth reflector configured to reflect the third set of light beams propagating from the third reflector onto the seventh reflector, the seventh reflector configured to reflect the third set of light beams propagating from the sixth reflector towards the second relay optics.

The first differential reflector can comprise a first dichroic reflector configured to at least partially reflect the first color and at least partially transmit the second color and the third color; and the second differential reflector can comprise a second dichroic reflector configured to at least partially reflect the second color and at least partially transmit the third color.

The light collection area can comprise an end of an integrating rod extending through the first support aperture, the end disposed between the second face and the first reflector.

### BRIEF DESCRIPTION OF THE DRAWINGS

Some implementations of the present specification will now be described, by way of example only, with reference to the attached Figures, wherein:
Fig. 1 shows a perspective view of an apparatus for combining light, according to non-limiting implementations.
Fig. 2 shows another perspective view of the apparatus shown in Fig. 1.
Fig. 3 shows a perspective view of another apparatus for combining light, according to non-limiting implementations.
Fig. 4 shows another perspective view of the apparatus shown in Fig. 3.
Fig. 5 shows a cross-sectional view of the apparatus shown in Fig. 3.
Fig. 6 shows a cross-sectional view of yet another apparatus for combining light, according to non-limiting implementations.
Fig. 7 shows a close-up of a portion of the apparatus shown in Fig. 6.
Fig. 8 shows a schematic view of a differential reflector, according to non-limiting implementations.
Fig. 9 shows a partial cross-sectional view of yet another apparatus for combining light, according to non-limiting implementations.
Fig. 10 shows a partial and schematic cross-sectional view of yet another apparatus for combining light, according to non-limiting implementations.
Fig. 11 shows a partial cross-sectional view of yet another apparatus for combining light, according to non-limiting implementations.
Fig. 12 shows a partial cross-sectional views of a stepped reflector and a faceted reflector, according to non-limiting implementations.
Fig. 13 shows a partial cross-sectional view of yet another apparatus for combining light, according to non-limiting implementations.
Fig. 14 shows a cross-sectional view of yet another apparatus for combining light, according to non-limiting implementations.
Fig. 15 shows a cross-sectional view of yet another apparatus for combining light, according to non-limiting implementations.
Fig. 16 shows a sectioned perspective view of the apparatus shown in Fig. 15.

### DETAILED DESCRIPTION

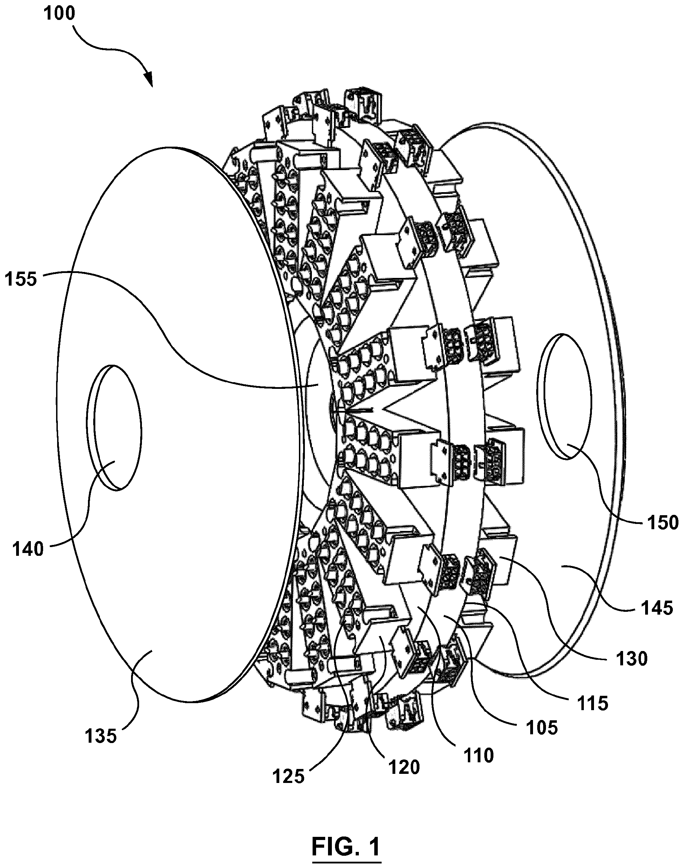

To address the challenges in bringing a large number of laser beams together and the need to accomplish this using an easy-to-fabricate and scalable structure, the present specification provides an apparatus 100 for combining light, as shown in Fig. 1. Apparatus 100 comprises a support 105 having a first face 110 and a second face 115 opposite first face 110. Support 105 also defines a support aperture 155 extending through first face 110 and second face 115. In apparatus 100, support 105 is shaped as a circular disk and support aperture 155 is shaped as a circular aperture concentric or substantially concentric with the circular disk of support 105. Support 105 can also be described as a circular plate and/or a circular sheet.

Apparatus 100 also comprises a receiving bank 120 disposed on and secured to first face 110. Receiving bank 120 is configured to receive a first set of light sources such as light source 125. Light sources 125 are configured to emit a first set of light beams. Light sources 125 can comprise laser diodes configured to emit laser beams. It is also contemplated that light sources 125 can comprise any other suitable light source other than laser diodes. Receiving bank 120 can comprise receiving sites configured to receive light sources 125. In Fig. 1, receiving bank 120 comprises eight receiving sites arranged in a 2x4 rectangular array. However, it is also contemplated that receiving bank 120 can comprise any other suitable number and/or arrangement of receiving sites.

In addition, Fig. 1 shows a plurality of other receiving banks disposed on first face 110. Receiving bank 120 and the other receiving banks disposed on first face 110 are arranged radially on first face 110. Apparatus 100 also comprises a second receiving bank 130, which is disposed on second face 115. Second receiving bank is similar in structure and function to first receiving bank 120. Apparatus 100 also comprises a plurality of other receiving banks disposed on second face 115, and receiving bank 130 and the other receiving banks are also arranged radially on second face 115. Each of the receiving banks can comprise a connection port extending from the receiving bank, which connection port can be used to electrically connect the light sources received in the receiving bank to a power source.

While in Fig. 1 the number, shape, and arrangement of receiving banks on first face 110 is shown as being the same as the number, shape, and arrangement of receiving banks on second face 115, it is contemplated that in apparatus 100 the receiving banks disposed on first face 110 can have a number, shape, and/or arrangement that is different from those of the receiving banks disposed on second face 115.

Apparatus 100 also comprises a first reflector 135 disposed to a side of support 105 opposite second face 115. In other words, first reflector 135 is disposed proximate but spaced from first face 110, and on the same side of support 105 as first face 110. The reflective surface of first reflector 135 faces first face 110. First reflector 135 is configured to intercept the set of light beams emitted by light sources 125 received in first receiving bank 120 and the other receiving banks disposed on first face 110, and to reflect those light beams towards support aperture 155. In apparatus 100, first reflector 135 has a curvature configured to increase the convergence of the light beams as they propagate from first reflector 135 towards support aperture 155. First reflector 135 can comprise a parabolic reflector or any other suitable shape and/or curvature.

Moreover, first reflector 135 can define a reflector aperture 140, which can be positioned at or near the center of first reflector 135. The general shape and size of first reflector 135 is selected so that it can intercept all the light beams emitted by the light sources 125 received in receiving banks on first face 110 of support 105. In apparatus 100, first reflector 135 has a generally circular shape.

Apparatus 100 also comprises a second reflector 145 disposed to a side of support 105 opposite first face 110. In other words, second reflector 145 is disposed proximate but spaced from second face 115, and on the same side of support 105 as second face 115. The reflective surface of second reflector 145 faces second face 115. Second reflector 145 is configured to intercept the set of light beams emitted by the light sources received in second receiving bank 130 and the other receiving banks disposed on second face 115, and to reflect those light beams towards support aperture 155. In shape and function, second reflector 145 can be similar to first reflector 135. Second reflector 145 can also define a reflector aperture 150 disposed at or near the center of second reflector 145.

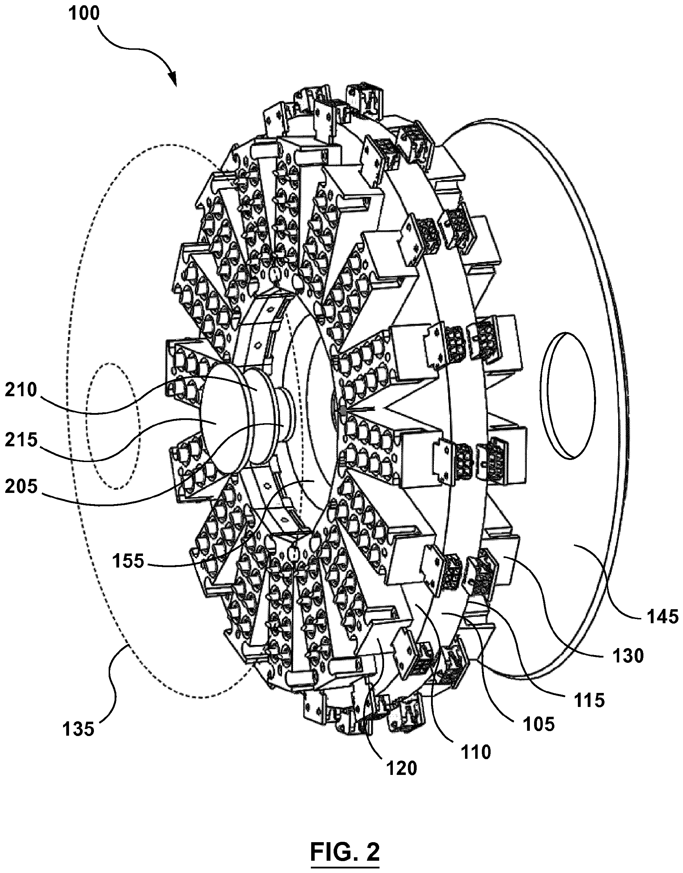

Fig. 2 shows another perspective view of apparatus 100 where first reflector 135 is depicted in a see-through manner to better show the features of apparatus 100 that would otherwise be obscured by first reflector 135. Fig. 2 shows the radial arrangement of the receiving banks on first face 110 of support 105. In addition, Fig. 2 shows a set of collection and/or collimating lenses comprising first lens 205, second lens 210, and third lens 215. These collection lenses are disposed on a side of support 105 opposite second face 115. Moreover, the collection lenses are disposed near support aperture 155 such that they can receive the light beams reflected by second reflector 145 towards and through support aperture 155. The structure and function of these collection lenses will be described in greater detail below.

While not shown in Figs. 1 and 2, apparatus 100 also comprises a differential reflector disposed in support aperture 155. In other implementations, the differential reflector can be positioned near support aperture 155. Generally, this differential reflector is positioned and configured to receive the light beams reflected from first reflector 135 and the light beams reflected from second reflector 145. The structure and function of the differential reflector will be described in greater detail below.

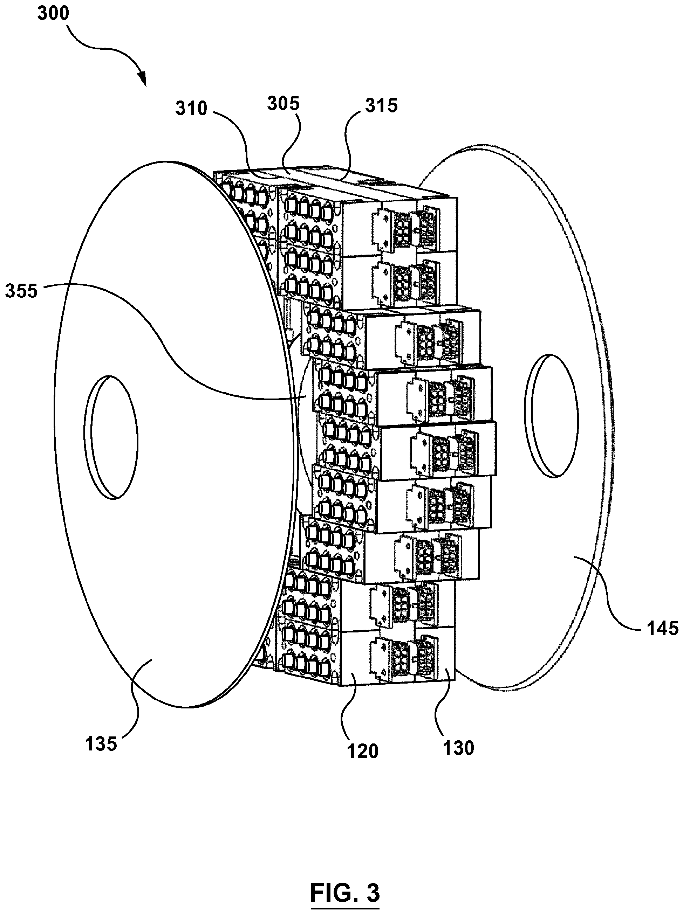

Fig. 3 shows a perspective view of apparatus 300 for combining light. Apparatus 300 is generally similar to apparatus 100, with the main difference being in the shape of the support and the arrangement of the receiving banks on the support. As shown in Figs. 1 and 2, in apparatus 100 support 105 is circular and the receiving banks are arranged radially on first face 110 and second face 115 of support 105. In contrast, in apparatus 300 the receiving banks are aligned parallel to one another and positioned side-by-side on a support 305. The receiving banks can be positioned such that each receiving bank abuts its neighboring receiving banks. Receiving bank 120 and other receiving banks parallel to it are disposed on first face 310 of support 305, while receiving bank 130 and other receiving banks parallel to it are disposed on second face 315 of support 305.

The shape and/or outer perimeter of support 305 is polygonal, and traces a shape similar to the shape defined by the arrangement and/or positioning of the receiving banks. Support 305 also defines a support aperture 355 extending through first face 310 and second face 315. Apparatus 300 also comprises a differential reflector (not shown in Fig. 3) disposed in support aperture 355, which differential reflector is generally similar to the differential reflector of apparatus 100.

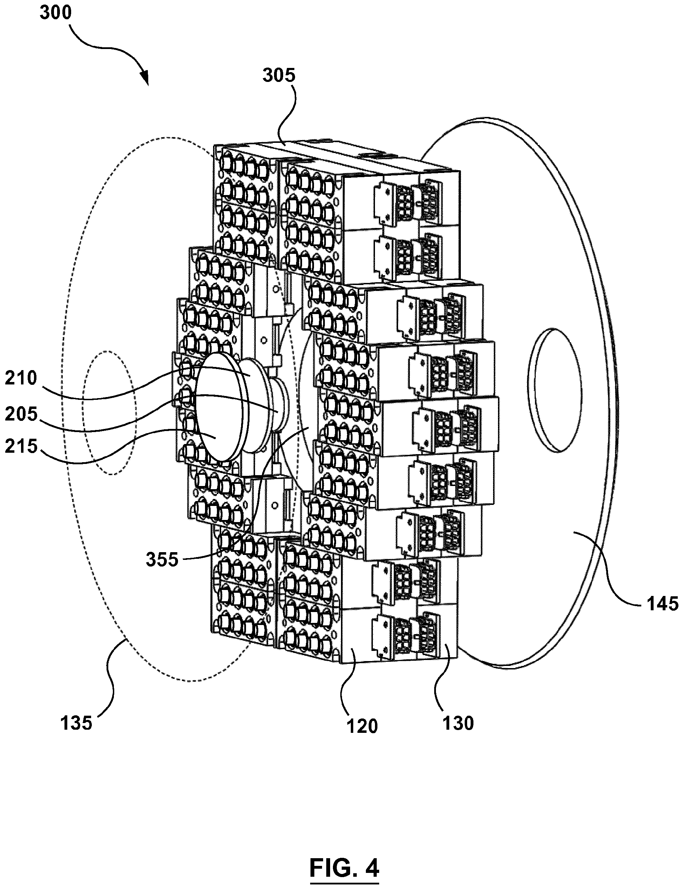

Fig. 4 shows another perspective view of apparatus 300 where first reflector 135 is depicted in a see-through manner to better show the features of apparatus 300 that would otherwise be obscured by first reflector 135. Fig. 4 shows the parallel, side-by-side arrangement of the receiving banks on first face 310 of support 305. In addition, Fig. 4 shows the set of collection and/or collimating lenses comprising first lens 205, second lens 210, and third lens 215. Similar to Fig. 2, these collection lenses are disposed on a side of support 305 opposite second face 315. Moreover, the collection lenses are disposed near support aperture 355 such that they can receive the light beams reflected by second reflector 145 through support aperture 355.

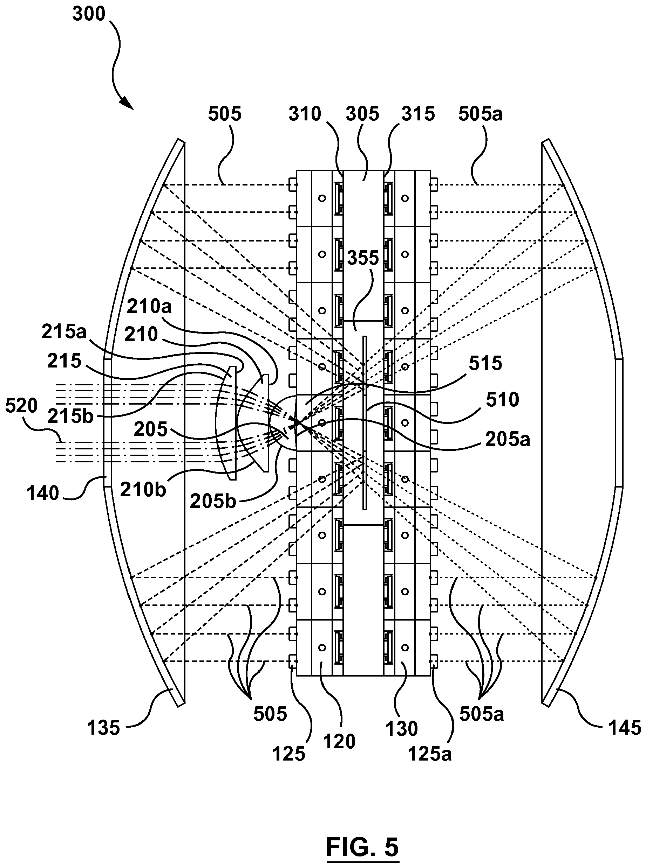

Fig. 5 shows a cross-section of apparatus 300, which shows a set of light beams 505 emitted by light sources 125 received in the receiving banks disposed on first face 310 of support 305. Light beams 505 are reflected by first reflector 135 towards support aperture 355 and are incident upon a differential reflector 510 disposed therein. The shape (i.e. curvature) of first reflector 135 increases the convergence of light beams 505 as they propagate from first reflector 135 towards differential reflector 510.

Fig. 5 also shows a set of light beams 505a emitted by light sources 125a received in the receiving banks disposed on second face 315 of support 305. Second reflector 145 reflects light beams 505a towards differential reflector 510, and the curvature of second reflector 145 increases the convergence of light beam 505a as they propagate from second reflector 145 towards differential reflector 510.

Differential reflector 510 is configured to reflect light beams 505 in a direction away from second reflector 145 and to transmit light beams 505a also in a direction away from second reflector 145. In apparatus 300, differential reflector 510 reflects light beams 505 towards first lens 205 and transmits light beams 505a through support aperture 355 and also towards first lens 205.

In apparatus 300 light beams 505 can have a different wavelength range than the wavelength range of light beams 505a. In other words, light beams 505 can be of a different color than light beams 505a. Differential reflector 510 can comprise, but is not limited to, a dichroic reflector configured to reflect light beams 505 while transmitting light beams 505a.

Both the light beams that are transmitted through and those that are reflected by differential reflector 510 pass through a diffuser 515 on their way to first lens 205. As shown in Fig. 5, diffuser 515 is disposed to the side of support opposite second face 315. Moreover, diffuser 515 is positioned to receive both the transmitted and the reflected light beams from differential reflector 510. Diffuser 515 is configured to form a diffused light by intercepting and at least partially transmitting light beams 505 reflected from differential reflector 510 and light beams 505a transmitted through differential reflector 510. While apparatus 300 comprises diffuser 515, it is contemplated that in some implementations there may be no diffuser and reflected and transmitted light beams can propagate from differential reflector 510 to first lens 205 without passing through a diffuser. Similar to apparatus 300, apparatus 100 can also comprise a diffuser similar in structure, function, and placement to diffuser 515.

Referring back to apparatus 300 shown in Fig. 5, first lens 205, second lens 210, and third lens 215 function together as collection and collimating optics. They receive the diffused light beams and reduce its divergence to produce output light beams 520, which propagate towards and exit through reflector aperture 140. First lens 205 is disposed proximate diffuser 515 and to a side of diffuser 515 opposite support 305, thereby allowing first lens 205 to efficiently receive and/or collect the diffused light emerging from diffuser 515. In the implementations which do not comprise diffuser 515, first lens 205 receives directly the light beams that are reflected by and transmitted through differential reflector 510.

First lens 205 comprises a first face 205a which is configured to receive at least a portion of the diffused light propagating from diffuser 515. First lens 205 also comprises a second face 205b opposite first face 205a. The relative shape and/or curvature of first face 205a to second face 205b is such that first lens 205 reduces the divergence of the light beams entering lens 205 through first face 205a and exiting lens 205 through second face 205b. In apparatus 300, first face 205a can be flat and/or concave while second face 205b is convex.

The light beams emerging from first lens 205 are then received into second lens 210 through a first face 210a and exit second lens 210 through a second face 210b of second lens 210. Second face 210b is opposite first face 210a, and similar to first lens 205, the relative curvature and/or shape of the two faces 210a and 210b allows second lens 210 to reduce the divergence of light beams that enter lens 210 through first face 210a and exit second lens 210 through second face 210b. In apparatus 300, first face 210a can be flat while second face 210b is convex.

The light beams emerging from second lens 210 are then received into third lens 215 through a first face 215a and exit third lens 215 through a second face 215b of third lens 215 to form output light beams 520. Second face 215b is opposite first face 215a, and similar to first lens 205 and second lens 210, the relative curvature and/or shape of the two faces 215a and 215b allows third lens 215 to reduce the divergence of the light beams that enter third lens 215 through first face 215a and exit third lens 215 through second face 215b. In apparatus 300, first face 215a is flat while second face 215b is convex.

While apparatus 300 is shown as having three lenses 205, 210, and 215 as part of its collection lenses/optics, it is contemplated that in some implementations, the apparatus can have only the first lens 205, or only the first lens 205 and the second lens 210. In addition, it is contemplated that the collection optics/lenses can comprise more than three lenses. Moreover, the collection lens or lenses can be of any suitable shape, configuration, and/or arrangement that can reduce a divergence of the diffused light or, if there is no diffuser, of the light received from differential reflector 510 into the collection lenses/optics.

In this manner, apparatus 300 can bring together light beams from a large number of light sources 125 and 125a without the need for vast arrays of fold mirrors. In addition, if more light sources need to be added, a larger diameter first reflector 135 and/or second reflector 145 can be used to accommodate the additional light beams. Moreover, the design of apparatus 300 allows for all the light sources to be received on a common support 305, which can comprise a cold plate and/or can be thermally connected to a heat sink and/or other active or passive cooling mechanisms. This, in turn, can facilitate cooling and/or thermal management of the light sources. Furthermore, if additional light sources need to be added, larger versions of first reflector 135 and/or second reflector 145 can be used, thereby obviating the need for additional fold mirrors to accommodate additional light sources.

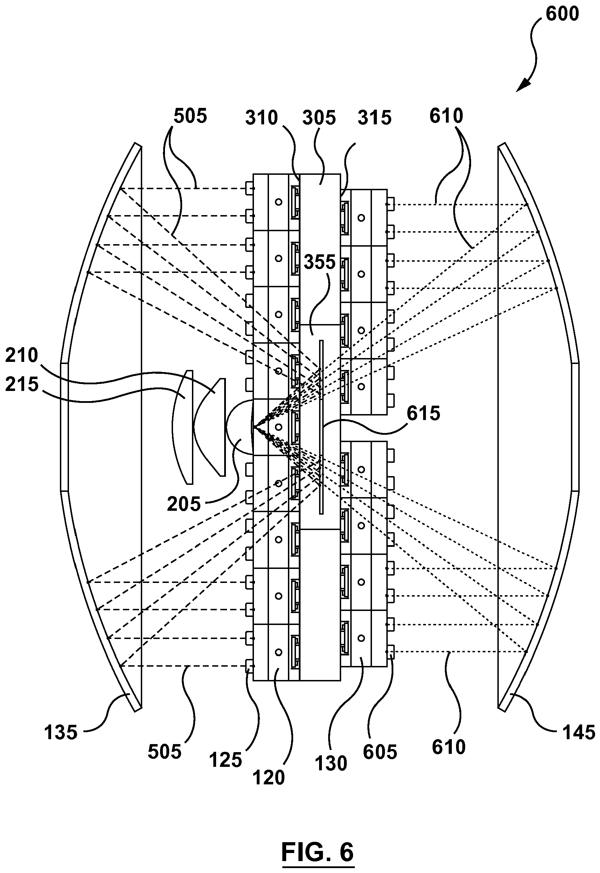

Turning now to Fig. 6, a cross-section of another apparatus 600 for combining light beams is shown. Apparatus 600 is generally similar to apparatus 300, with the main differences being in the arrangement and/or positioning of the receiving banks on second face 315, the light sources received in the receiving banks disposed on second face 315 and the light beams emitted by them, and the structure and function of the differential reflector disposed in support aperture 355.

In apparatus 600, the arrangement and/or positioning of receiving banks 130 on support 305, and therefore those of light sources 605 received therein, are different than the arrangement and/or positioning of light sources 125 received in receiving banks 120 disposed on first face 310. As a result of this difference in positioning, light beams 610 generated by light sources 605, after being reflected by second reflector 145, are incident upon differential reflector 615 at points/positions that are different from the corresponding points where light beams 505 are incident upon differential reflector 615. As such, differential reflector 615 can selectively reflect light beams 505 and transmit light beams 610 based on the position where those beams are incident upon differential reflector 615.

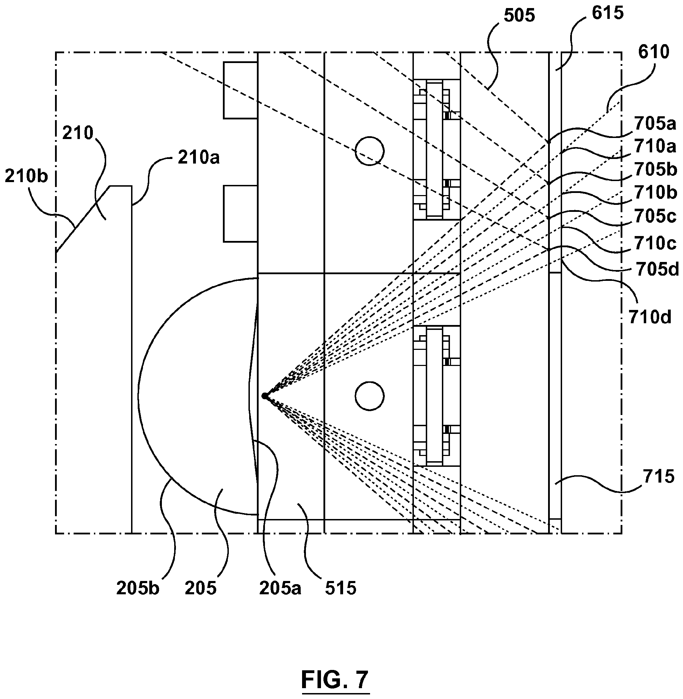

Fig. 7 depicts a partial close-up of the differential reflector 615 of apparatus 600, showing the difference in the set of positions 705a, 705b, 705c, and 705d (hereinafter collectively 705a-d) where light beams 505 are incident upon differential reflector 615 and the set of positions 710a, 710b, 710c, and 710d (hereinafter collectively 710a-d) where light beams 610 are incident upon differential reflector 615. While only four positions are shown for each of light beams 505 and light beams 610, the skilled person would understand that these sets of four positions are exemplary only and shown for illustrative purposes, and that in apparatus 600 there can be many more (or even fewer) light beams and therefore many more (or fewer) corresponding points of incidence of light beams 505 and 610 on differential reflector 615.

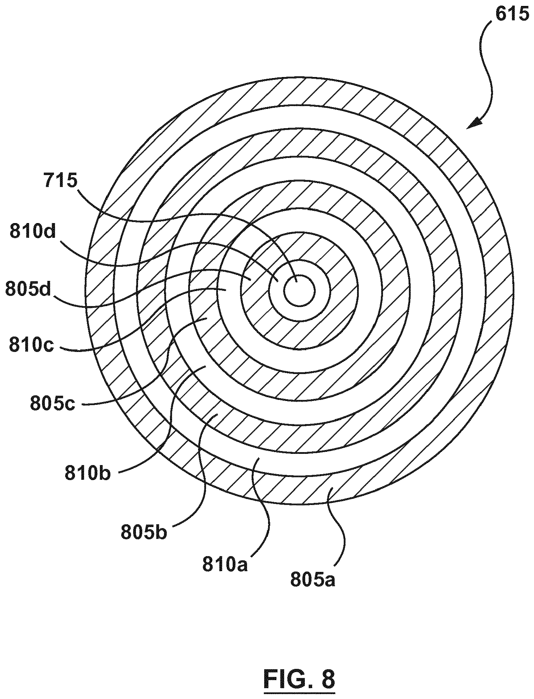

Differential reflector 615 comprises reflective regions at positions 705a-d and transmissive regions at positions 710a-d. This, in turn, allows differential reflector 615 to reflect light beams 505 towards diffuser 515 and first lens 205, while transmitting light beams 610 also towards diffuser 515 and first lens 205. In the exemplary and non-limiting implementation shown in Fig. 8, differential reflector 615 can comprise concentric, alternating rings of reflective regions 805a, 805b, 805c, and 805d (hereinafter collectively 805a-d) and transmissive regions 810a, 810b, 810c, and 810d (hereinafter collectively 810a-d). Reflective regions 805a-d can correspond to positions 705a-d, and transmissive regions 810a-d can correspond to positions 710a-d.

The skilled person would understand that the placement of positions 705a-d and 710a-d depends on the placement/positioning of light sources 125 and 605 respectively. As such, the pattern of reflective and transmissive regions in differential reflector 615 can be any pattern suitable for reflecting light beams 505 incident upon differential reflector 615 at positions 705a-d and for transmitting light beams 610 incident upon differential reflector 615 at potions 710a-d. Since the differential reflection and transmission of light beams 505 and 610 are performed spatially, in apparatus 600 there is no need for light beams 505 and 610 to be of different color or wavelength distribution.

Referring to Figs. 7 and 8, differential reflector 615 can also comprise a further transmissive region 715 which can be used to optically couple, i.e. gang together, two or more apparatuses 600, as will be described in greater detail below. Transmissive region 715 can be positioned at or near the center of differential reflector 615. Moreover, referring to Figs. 6 and 7, for ease of illustration light beams are not depicted past diffuser 515. However, the path of the light beams past diffuser 515 in Figs. 6 and 7 is similar to the path of light beams past diffuser 515 in Fig. 5.

Support 105 and support 305 can be made of any suitable material including, but not limited to, metals, metal alloys, and the like. While support 105 is shown as having a circular shape and support 305 is shown as having a polygonal shape, it is contemplated that the support can have any suitable shape, including but not limited rounded shapes, oval shapes, and other polygons including regular polygons. Moreover, while support apertures 155 and 355 are shown in Figs. 1, 3, and 6 as being at or near the center of their respective supports, it is contemplated that support apertures can be located at a different position in their respective support.

In addition, while in apparatuses 100, 300, and 600 the light sources are received in receiving banks that are then disposed on and secured to their respective supports, it is contemplated that in other implementations light source can be secured directly to the support or otherwise secured to the support using any other suitable method. In yet other implementations, the apparatuses need not comprise a support; for example, the receiving banks can be secured to one another to support the light sources in their respective positions.

Moreover, in apparatuses 100, 300, and 600, the receiving banks are arranged either radially or parallel with one another. However, it is also contemplated that the receiving banks, and the light sources received therein, can be positioned in any other suitable arrangement. In addition, while in apparatuses 100 and 300 the receiving banks on the first side of the support are positioned in the same arrangement as the receiving banks on the second side, it is contemplated that receiving banks on the first side can be positioned in an arrangement different than the receiving banks on the second side.

Turning now to the first and second reflectors, they are shown as being identical to one another in apparatuses 100, 300, and 600. However, it is also contemplated that in each of these apparatuses, the first reflector can have a shape, size, curvature, and/or distance from the support than can be different from the shape, size, curvature, and/or distance from the support of the second reflector. Moreover, it is contemplated that in some implementations the second reflector need not have a reflector aperture. For example, variations of apparatuses 100, 300, and 600 are contemplated where only first reflector 135 defines reflector aperture 140, and second reflector 145 has no aperture.

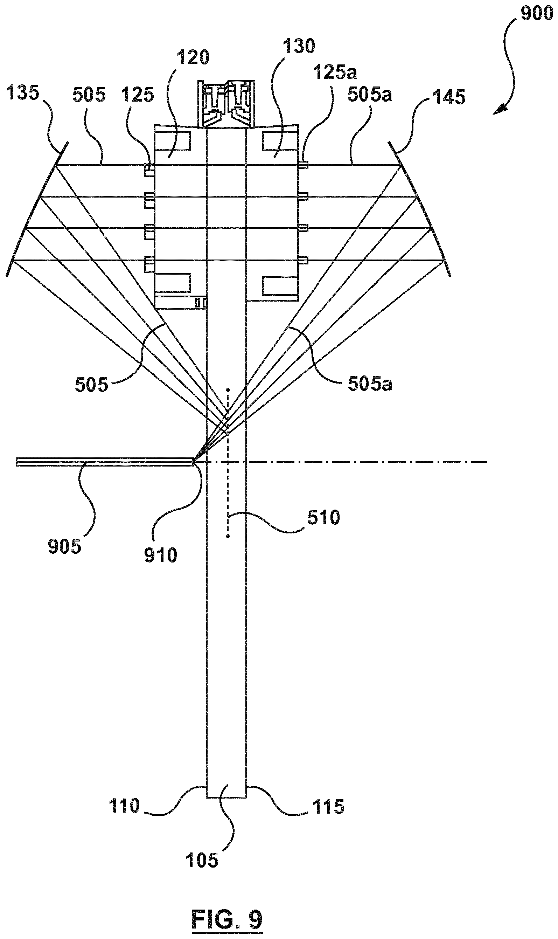

Turning now to Fig. 9, a partial cross-section of an apparatus 900 is shown, which apparatus can be used for combining light beams. Apparatus 900 is generally similar to apparatus 100, in that apparatus 900 comprises support 105 having first face 110 and second face 115. In addition, apparatus 900 comprises receiving bank 120 disposed on first face 110 and receiving bank 130 disposed on second face 115. Light sources 125 are received in receiving bank 120 and emit light beams 505 which are reflected by first reflector 135 towards differential reflector 510 disposed in the support aperture. Similarly, light sources 125a are received in receiving bank 130 and emit light beams 505a which are reflected by second reflector 145 towards differential reflector 510 disposed in the support aperture.

Differential reflector 510 reflects light beams 505 while transmitting light beams 505a, both in a direction away from second reflector 145. Apparatus 900 is different from apparatus 100 in that instead of a set of collection lenses, apparatus 900 comprises an integrating rod 905 having an end 910. End 910 is disposed proximate first face 110 and is positioned to receive light beams 505 that are reflected from differential reflector 510 and to also receive light beams 505a which are transmitted through differential reflector 510. Generally, end 910 can be positioned in a position similar to the position of diffuser 515 as shown in Fig. 5, and/or in a position similar to the position of first lens 205, also shown in Fig. 5. Position of end 910 can be selected to allow end 910 to receive both the light beams that are reflected by differential reflector 510 and the light beams that are transmitted through differential reflector 510.

While apparatus 900 comprises differential reflector 510, it is contemplated that in some implementations, differential reflector 615 can be used instead of reflector 510. In addition, while Fig. 9 shows only one receiving bank on each face of support 105, it is contemplated that apparatus 900 can comprises a plurality of receiving banks on one or both faces of support 105, similar to apparatuses 100 and 300. Moreover, Fig. 9 shows schematically only a small portion of each of first reflector 135 and second reflector 145. While not shown in Fig. 9, first reflector 135 and second reflector 145 of apparatus 900 can be similar to the first and second reflectors of apparatus 100 and 300.

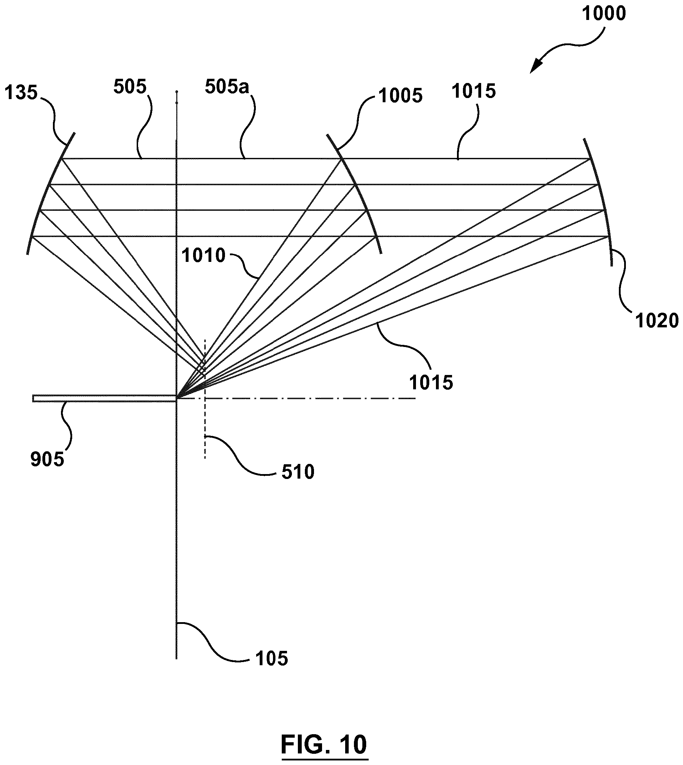

Turning now to Fig. 10, another apparatus 1000 for combining light is shown partially and schematically. Apparatus 1000 can be generally similar to apparatus 900 in that apparatus 1000 comprises support 105 (shown schematically as a line) and light sources on one face of support 105 that emit light beams 505 that are reflected by first reflector 135 towards differential reflector 510. Differential reflector, in turn, reflects light beams 505 towards integrating rod 905.

Apparatus 1000 also comprises light sources on the second face of support 105 that emit light beams 505a. Apparatus 1000 is different from apparatus 900 in that apparatus 1000 comprises a beam splitter 1005 instead of second reflector 145 of apparatus 900. Beam splitter 1005 can be in the same position relative to support 105 and can have the same shape and/or curvature as second reflector 145. Beam splitter 1005 reflects a first portion of light beams 505a to form reflected beams 1010 propagating towards differential reflector 510, which can be disposed in the support aperture (not shown) of support 105. Shape and or curvature of beam splitter 1005 can increase a convergence of reflected beams 1010 as they propagate from beam splitter 1005 towards differential reflector 510.

Beam splitter 1005 also transmits a second portion of light beams 505a to form transmitted beams 1015. Apparatus 1000 also comprises a third reflector 1020 disposed to a side of beam splitter 1005 opposite the side that support 105 is on. In other words, beam splitter 1005 is disposed between third reflector 1020 and support 105. Third reflector 1020 can have a reflective surface facing the second face of support 105. Third reflector 1020 is positioned to intercept transmitted beams 1015 and to reflect them towards differential reflector 510, which can be disposed in the support aperture of support 105. Shape and/or curvature of third reflector 1020 is configured to increase the convergence of transmitted beams 1015 as they propagate from third reflector 1020 towards differential reflector 510.

Differential reflector 510, in turn, reflects beams 505 and transmits beams 1010 and 1015 towards integrating rod 905. The use the combination of beam splitter 1005 and third reflector 1020 can expand the range of angles through which light beams 505a enter integrating rod 905. For example, instead of having only the angles of propagation of reflected beams 1010, apparatus 1000 also provides transmitted beams 1015 which enter integrating rod 905 at shallower angles. This, in turn, increases the angular diversity of the light beams entering integrating rod 905, and can enhance the homogeneity of the light output from integrating rod 905.

Fig. 10 shows schematically only a portion of reflector 135, beam splitter 1005, and reflector 1020. It is contemplated that reflectors 135 and 1020 and beam splitter 1005 can have a shape that is rotationally symmetrical about the optical axis defined by the long axis of integrating rod 905. In other words, reflector 135 can resemble reflector 135 shown in Figs. 1 and 3, and beam splitter 1005 and reflector 1020 can comprise reflector 145 shown in Figs 1 and 3. Moreover, it is contemplated that beam splitter 1005 can define a beam splitter aperture (not shown) centered at or around the optical axis to allows transmitted beams 1015 to propagate from reflector 1020 towards differential reflector 510. Reflector 1020 may or may not define a corresponding reflector aperture.

Third reflector 1020 can comprise a curved reflector including, but not limited, to a parabolic reflector and the like. Similarly, in some implementations beam splitter 1005 can have a parabolic shape. In addition, Fig. 10 shows only a schematic representation of support 105, and only representative light beams 505 and 505a are shown. It is contemplated that apparatus 1000 can comprise receiving banks similar to those shown in Figs. 1 and 2, and/or can have any other suitable arrangement of receiving banks and/or light sources.

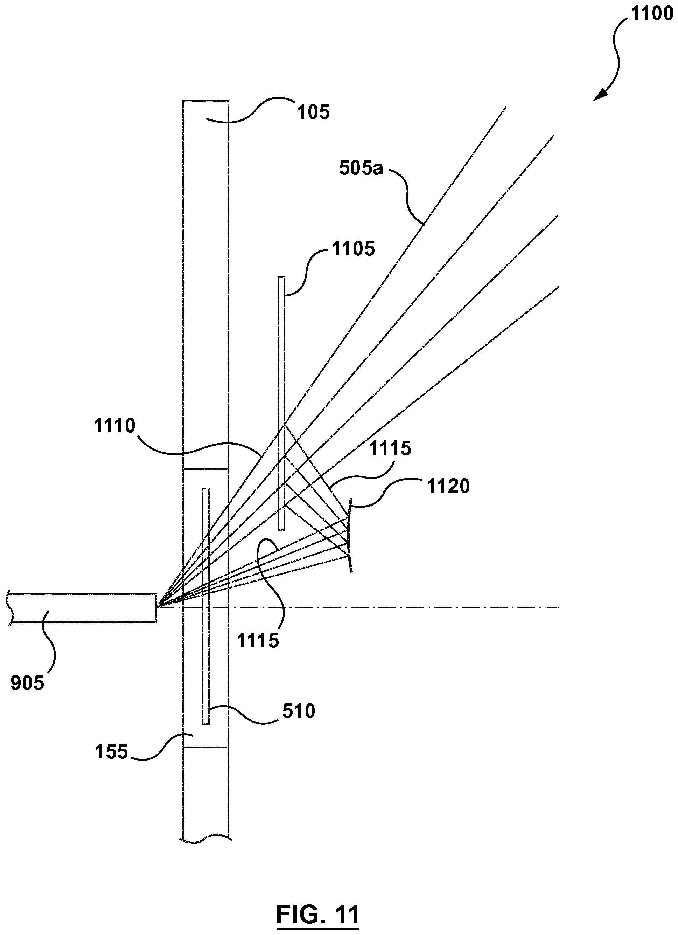

Turning now to Fig. 11, an apparatus 1100 for combining light is shown partially and schematically. Apparatus 1100 can be generally similar to apparatus 900, with the main difference being that apparatus 1100 comprises beam splitter 1105 positioned to intercept light beams 505a propagating from second reflector 145 (not shown in Fig. 11, but shown in Fig. 9) towards differential reflector 510 disposed in support aperture 155. Beam splitter 1105 is configured to transmit a portion of light beams 505a to form transmitted beams 1110 propagating towards differential reflector 510.

Beam splitter 1105 also reflects a portion of light beams 505a to form reflected beams 1115. Apparatus 1100 also comprises an additional reflector 1120 disposed to a side of beam splitter 1105 opposite the side that support 105 is on. In other words, beam splitter 1105 is disposed between support 105 and reflector 1120. Reflector 1120 comprises a reflective surface facing the second face of support 105. Reflector 1120 is configured to reflect reflected beams 1115 towards differential reflector 510 and integrating rod 905. In some implementations, reflector 1120 can have a curvature configured or increase or decrease the convergence of reflected beams 1115. Moreover, beam splitter 1105 can be shaped as a flat plane, or can have any other suitable shape and/or curvature.

Similar to apparatus 1000, the use of the combination of beam splitter 1105 and reflector 1120 in apparatus 1100 increases the diversity of angles at which light beams 505a enter integrating rod 905. Specifically, the combination of beam splitter 1105 and reflector 1120 separates reflected beams 1115 from beams 505a and directs reflected beams 1115 to enter integrating rod 905 at shallower angles compared to light beams 505a and/or transmitted beams 1110. Beam splitter 1005 and beam splitter 1105 can each comprise a 50/50 beam splitter, or can have any other suitable ratio of reflectivity to transmission.

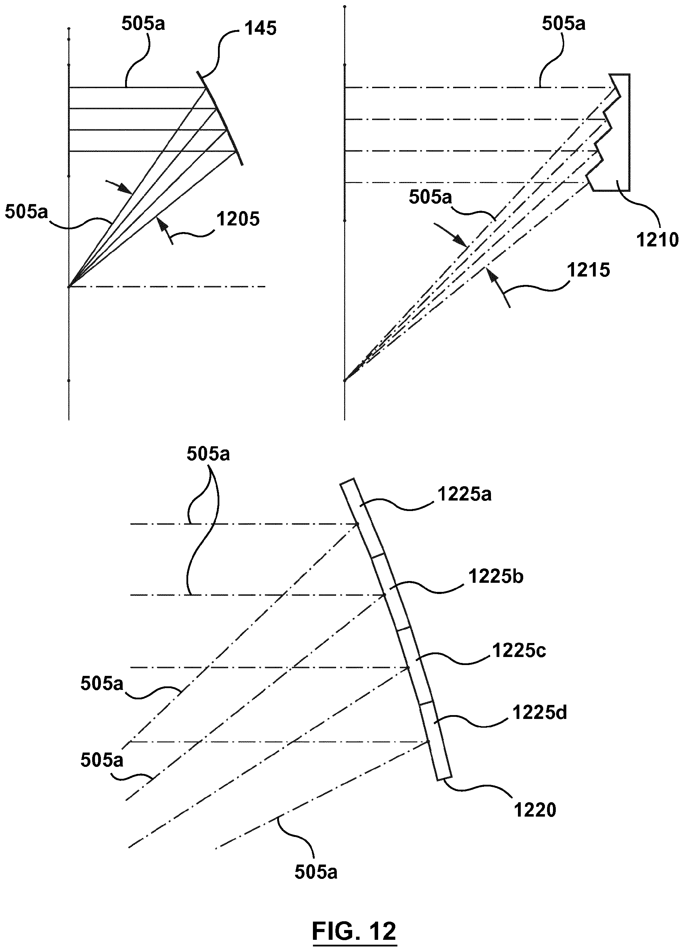

Fig. 12 shows a schematic and partial cross-sectional representation of a stepped reflector 1210 that can be used instead of and/or in addition to one or more of first reflector (not shown in Fig. 12, but shown in Figs. 1 and 9) and second reflector 145. Fig. 12 shows a side-by-side comparison of light beams 505a reflected by curved second reflector 145 with light beams 505a reflected by stepped reflector 1210. Stepped reflector 1210 can be used to generate reflected light beams 505a that have an angle of convergence 1215 that is smaller than a corresponding angle of converge 1205 of light beams 505a reflected by the curved second reflector 145. The shape and geometry of stepped reflector 1210 can be adjusted to adjust the angle of convergence 1215 of the light beams reflected from stepped reflector 1210.

In addition, Fig. 12 shows a schematic and partial cross-sectional representation of a faceted reflector 1220, which comprises facets 1225a, 1225b, 1225c, and 1225d (hereinafter collectively 1225a-d). Faceted reflector 1220 can optically function in a manner similar to stepped reflector 1210, with each facet 1225a-d of faceted reflector 1220 reflecting light beams 505a in a manner similar to the way steps of stepped reflector 1210 reflect light beams 505a.

Each of the facets 1225a-d can be flat and/or curved. Each facet can have a shape, curvature, and/or geometry that is the same as or different from the shape, curvature, and/or geometry of the other facets. Moreover, while Fig. 12 shows faceted reflector 1220 as comprising only four facets 1225a-d with one light beam 505a reflecting from each facet, it is contemplated that faceted reflector 1220 can comprise any suitable number of facets, and zero or any number of light beams can reflect from one or more of the facets. In some implementations, faceted reflector 1220 can be integrally formed; i.e. facets 1225a-d can each comprise one portion of a unitary faceted reflector 1220. In other implementations, some or all of the facets can be independent, spaced, and/or otherwise separate from one another.

Fig. 12 shows only schematic and partial representations of reflector 145, stepped reflector 1210, and faceted reflector 1220. Reflector 145, stepped reflector 1210, and faceted reflector 1220 can have a shape that is rotationally symmetrical about the optical axis of the apparatus, i.e. a shape that is similar to the shape of second reflector 145 and/or first reflector 135 shown in Fig. 1. In some implementations, stepped reflector 1210 can define a stepped reflector aperture and/or faceted reflector 1220 can define a faceted reflector aperture, each similar to reflector aperture 150 of second reflector 145, shown in Fig. 1.

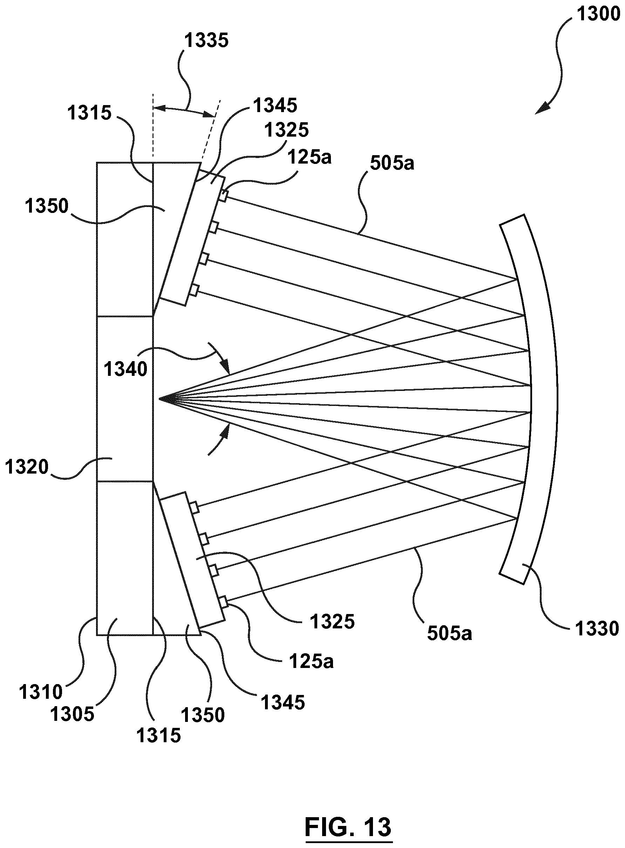

Turning now to Fig. 13, a cross-section of an apparatus 1300 is shown, which apparatus can be used for combining light beams. Similar to apparatuses 100 and 300, apparatus 1300 comprises a support 1305 having a first face 1310 and a second face 1315 opposite first face 1310. Support 1305 also comprises a support aperture 1320 extending through first face 1310 and second face 1315.

In addition, apparatus 1300 comprises receiving banks 1325 disposed on a plane 1345 inclined relative to second face 1315 by an angle of incline 1335. Light sources 125a can be received in receiving banks 1325, and can be configured to emit light beams 505a. Apparatus 1300 can also comprise a reflector 1330 disposed to the side of support 1305 opposite first face 1310. Reflector 1330 can have a reflective surface facing second face 1315. Moreover, reflector 1330 can be configured to reflect light beams 505a towards support aperture 1320 and to increase the convergence of light beams 505a as they propagate from reflector 1330 towards support aperture 1320.

In some implementations, reflector 1330 can have a curvature configured to increase the convergence of light beams 505a, including but not limited to, a parabolic curvature, and the like. Angle of incline 1335 can determine the angle of light beams 505a relative to reflector 1330, which can in turn determine the angle of convergence 1340 of reflected light beams 505a. By inclining receiving banks 1325 and thereby light beams 505a, apparatus 1300 can achieve a smaller angle of convergence 1340 relative to the corresponding convergence angle in the similar apparatus (e.g. apparatuses 100 and 300) where the receiving banks are not inclined and the laser beams are about perpendicular to the faces of the support.

While in Fig. 13 reflected light beams 505a are shown as converging near second face 1315, it is contemplated that in some implementations reflected light beams 505a can converge within support aperture 1320 or at a point to a side of support 1305 opposite second face 1315. The point of convergence of light beams 505a propagating towards support aperture 1320 can be adjusted by adjusting one or more of: the angle of light beams 505a propagating towards reflector 1330, the shape and/or curvature of reflector 1330, and the distance of reflector 1330 from support 1305.

In some implementations, wedges 1350 creating inclined planes 1345 can be formed integrally with support 1305. In other implementations, there can be no wedges or inclined planes, and light sources 125a can be oriented at an inclined angle (i.e. angle other than 90°) to second face 1315. Moreover, while Fig. 13 shows only one annular "row" of receiving banks 1325 proximate second face 1315 and no receiving banks on first face, it is contemplated that apparatus 1300 can comprise additional receiving banks on second face 1315 and/or on inclined plane 1345, and/or can comprise receiving banks on first face 1310.

In addition, while only one reflector 1330 is shown, it is contemplated that apparatus 1300 can comprise a second reflector similar to reflector 1330, which second reflector can be disposed to the side of support 1305 opposite second face 1315. In other words, it is contemplated that apparatus 1300 can have two reflectors, one on either side of support 1305, similar to apparatuses 100 and 300. Moreover, in some implementations, one or more of reflector 1330 and the second reflector can define a reflector aperture, similar to those shown in Figs 1 and 3.

It is contemplated that inclining the light beams propagating towards the reflector can be used also in the other apparatuses described herein to achieve smaller convergence angles of the light beams reflected by the reflectors.

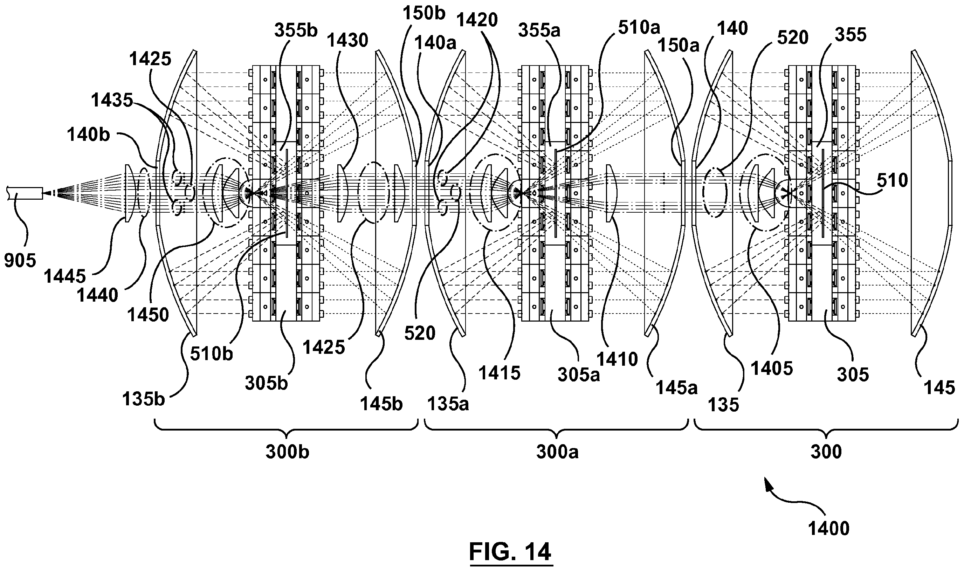

Turning now to Fig. 14, a cross-section of an apparatus 1400 is shown for combining light beams. Apparatus 1400 comprises three apparatuses 300, 300a, and 300b optically coupled and/or ganged together, i.e. arranged optically in series. Apparatuses 300a and 300b are similar in structure and function to apparatus 300. Apparatus 1400 also comprises lens 1445 which receives combined output beams 1440 propagating from apparatus 300b and directs combined output beams 1440 towards and into integrating rod 905.

As discussed above, apparatus 300 combines the light beams from light sources disposed in receiving banks on the first and second faces of support 105. These combined beams pass through collection optics 1405 (comprising lenses 205, 210, and 215 shown also in Fig. 5) and emerge to form output light beams 520 propagating towards and through reflector aperture 140.

Output light beams 520 enter apparatus 300a through reflector aperture 150a in first reflector 145a. Output light beams 520 then pass through lens 1410, which is configured to converge output light beams 520 as they propagate towards differential reflector 510a disposed in support aperture 355a of support 305a. In addition, apparatus 300a combines light beams from the light sources received in receiving banks disposed on the first and second faces of its support 305a, to form output light beams 1420. Output light beams 1420, in turn, pass through collection optics 1415, which can be similar in structure and function to collection optics 1405.

Output light beams 520 are transmitted by differential reflector 510a, and also pass through collection optics 1415. The combination of output light beams 520 and output light beams 1420 propagates from collection optics 1415 towards and through reflector aperture 140a of reflector 135a. Differential reflector 510a can have a central transmissive region similar to differential reflector aperture 715 (shown in Fig. 7), which transmissive region can be configured for transmitting output light beams 520 converged by lens 1410 onto differential reflector 510a.

Output light beams 520 and output light beams 1420 enter apparatus 300b through reflector aperture 150b in first reflector 145b to form combined output light beams 1425. Combined output light beams 1425 then pass through lens 1430, which is configured to converge combined output light beams 1425 as they propagate towards differential reflector 510b disposed in support aperture 355b of support 305b. In addition, apparatus 300b combines light beams from the light sources received in receiving banks disposed on the first and second faces of its support 305b, to form output light beams 1435. Output light beams 1435, in turn, pass through collection optics 1450, which can be similar in structure and function to collection optics 1405.

Output light beams 1425 are transmitted by differential reflector 510b, and also pass through collection optics 1450. The combination of output light beams 1425 and output light beams 1435 propagates from collection optics 1450 towards and through reflector aperture 140b of reflector 135b. Differential reflector 510b can have a central transmissive region similar to differential reflector aperture 715 (shown in Fig. 7), which transmissive region can be configured for transmitting output light beams 1425 converged by lens 1430 onto differential reflector 510b.

The combination of output light beams 1425 and 1435 can form combined output light beams 1440, which propagate out of reflector aperture 140b of reflector 135b and are converged by lens 1445 towards and into integrating rod 905. By optically combining (i.e. ganging together) three apparatus 300, 300a, and 300b, apparatus 1400 can combine and bring together an even larger number of laser beams than can be combined using one of the three apparatuses alone.

In addition, the combination of multiple apparatuses can generate a final output light beam that is more angularly diverse and more homogeneous than can be achieved using only one of the apparatuses. For example, it can be seen that output light beams 520 do not comprise any light beams in the central region of the collimated light beams. When combined with output light beams 1420 to form combined output light beams 1425, output light beams 520 at least partially fill in the central portion of output light beams 1420. When combined output light beams 1425 pass through apparatus 300b, the combined output light beams 1425 further fills in the center portion of output light beam 1435, to yield combined output light beams 1440 that have an even higher homogeneity and angular diversity when they are converged into integrating rod 905.

While Fig. 14 shows three apparatuses similar to apparatus 300 which are combined together, it is contemplated that any number of light combining apparatus can be optically combined in the manner shown in Fig. 14. In addition, it is contemplated that one or more of the combined apparatuses can be similar to apparatus 100, 600, 1300, or any of the other apparatuses described herein.

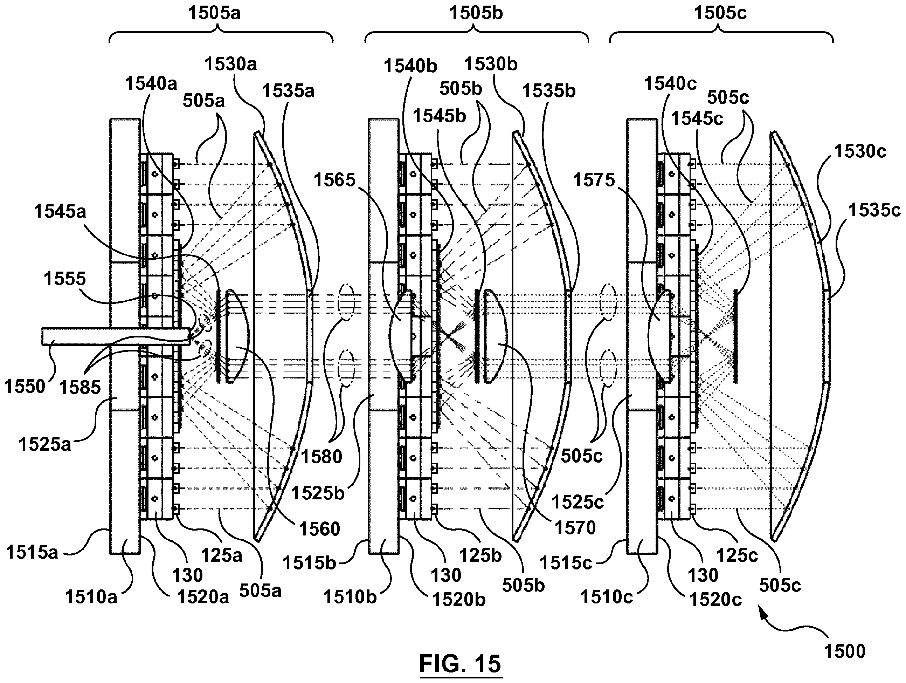

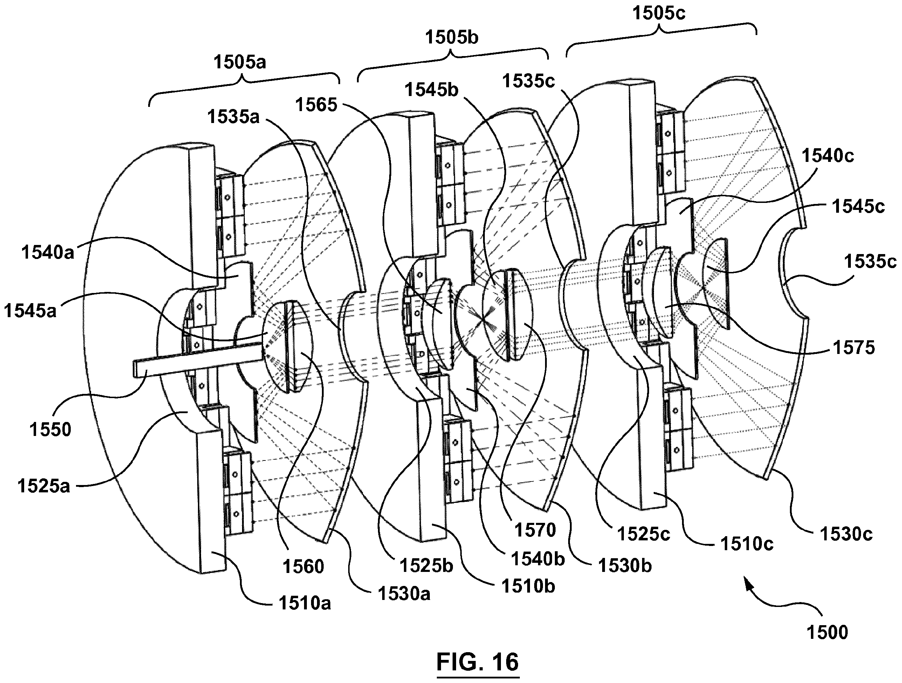

Turning now to Figs. 15 and 16, an apparatus 1500 is shown for combining light beams. Fig. 15 shows a cross-section of apparatus 1500 while Fig. 16 shows a sectioned perspective view of apparatus 1500. Apparatus 1500 comprises three similar light collecting units 1505a, 1505b, and 1505c optically coupled with one another in series. Light collecting unit 1505a comprises a combination of a support, receiving banks disposed on a face of the support, and a reflector, which combination is similar to the corresponding combinations in apparatuses 100 and 300.

Light collecting unit 1505a comprises a support 1510a having a first face 1515a and a second face 1520a opposite first face 1515a. Support 1510a also defines a support aperture 1525a extending through first face 1515a and second face 1520a. Light collecting unit 1505a also comprises receiving banks 130 disposed on second face 1520a. Light sources 125a can be received in receiving banks 130 and can emit light beams 505a.

Light collecting unit 1505a also comprises a reflector 1530a defining a reflector aperture 1535a. Reflector 1530a is disposed proximate second face 1520a and comprises a reflective surface facing second face 1520a. Furthermore, first reflector 1530a is spaced from second face 1520a and is positioned to intercept light beams 505a. Moreover, first reflector 1530a is configured to reflect light beams 505a towards second face 1520a. Shape and/or curvature of reflector 1530a is configured to increase the convergence of light beams 505a reflected from reflector 1530a. In some implementations, first reflector 1530a can comprise a parabolic reflector.

Light collecting unit 1505a is different from apparatuses 100 and 300 in that light collecting unit 1505a comprises no receiving banks on first face 1515a and no reflector on a side of support 1510a opposite second face 1520a. Moreover, unlike apparatuses 100 and 300, light collecting unit 1505a does not have a differential reflector disposed in support aperture 1525a.

Light collecting units 1505b and 1505c have a structure and function similar to light collecting unit 1505a. Light collecting unit 1505b comprises support 1510b having a first face 1515b, a second face 1520b, and a support aperture 1525b. Light collecting unit 1505b also comprises receiving banks 130 disposed on second face 1520b, which can receive light sources 125b that emit light beams 505b propagating towards reflector 1530b. Light beams 505b are of a different color than light beams 505a. Reflector 1530b defines reflector aperture 1535b. In addition, reflector 1530b is configured to reflect light beams 505b towards second face 1520b and to also increase a convergence of light beams 505b reflected from reflector 1530b.

Light collecting unit 1505b is disposed side-by-side with light collecting unit 1505a such that support 1510b is disposed side-by-side and/or parallel or substantially parallel with support 1510a. In this arrangement, second face 1520a of support 1510a faces first face 1515b of support 1510b, and reflector 1530a is disposed between support 1510a and support 1510b.

Similar to light collecting unit 1505b, light collecting unit 1505c comprises a support 1510c having a first face 1515c, a second face 1520c, and a support aperture 1525c. Light collecting unit 1505c also comprises receiving banks 130 disposed on second face 1520c, which can receive light sources 125c that emit light beams 505c propagating towards reflector 1530c. Light beams 505c are of a different color than light beams 505a and 505b. Reflector 1530c defines reflector aperture 1535c. In addition, reflector 1530c is configured to reflect light beams 505c towards second face 1520c and to also increase a convergence of light beams 505c reflected from reflector 1530c.

Light collecting unit 1505c is disposed side-by-side with light collecting unit 1505b such that support 1510c is disposed side-by-side and/or parallel or substantially parallel with support 1510b. In this arrangement, second face 1520b of support 1510b faces first face 1515c of support 1510c, and reflector 1530b is disposed between support 1510b and support 1510a.

In addition, apparatus 1500 also comprises a reflector 1540a configured to reflect light beams 505a propagating from reflector 1530a and to reflect those light beams 505a onto a differential reflector 1545a. Differential reflector 1545a, in turn, is configured to reflect light beams 505a towards a light collection area. Reflector 1540a can comprise an annular reflector (as shown in Fig. 16) disposed on a side of support 1510a opposite first face 1515a, and between second face 1520a and reflector 1530a. Differential reflector 1545a can be disposed between reflector 1545a and reflector 1530a. Moreover, differential reflector 1545a can comprise a dichroic reflector configured to reflect light beams 505a and transmit light beams 505b and 505c.

In light collecting unit 1505a, the light collection area comprises end 1555 of integrating rod 1550, which integrating rod 1550 extends through support aperture 1525a such that end 1555 is disposed between second face and reflector 1530a. In particular, end 1555 is disposed between reflector 1540a and differential reflector 1545a. In some implementations, the collection area can be another region and/or point or points in space to the side of support 1510a opposite first face 1515a. In other implementations, the light collection area can comprise a region and/or point or points in space within support aperture 1525a or on a side of support 1510a opposite second face 1520a.

Apparatus 1500 also comprises reflector 1540b and differential reflector 1545b, which have a similar structure as reflector 1540a and differential reflector 1545a. Reflector 1540b can have a function similar to the function of reflector 1540a. Moreover, reflector 1540b and differential reflector 1545b are positioned in relation to light collecting unit 1505b in positions similar to the positioning of reflector 1540a and differential reflector 1545a in relation to light collecting unit 1505a. Differential reflector 1545b can comprise a dichroic reflector configured to reflect light beams 505b and transmit light beams 505c.

Apparatus 1500 also comprises reflector 1540c and reflector 1545c. Reflector 1540c can have a similar structure and function as reflector 1540a. Reflector 1545c can have a shape similar to the shape of differential reflector 1545a. Moreover, reflector 1540c and reflector 1545c are positioned in relation to light collecting unit 1505c in positions similar to the positioning of reflector 1540a and differential reflector 1545a in relation to light collecting unit 1505a. In some implementations, reflector 1545c can comprise a dichroic reflector configured to reflect light beams 505c and transmit light beams of colors different that the color of light beams 505c.

Apparatus 1500 also comprises a first relay optics configured to receive output light beams 1580 from light collecting unit 1505b and direct output light beams 1580 through support aperture 1525b and reflector aperture 1535a, and onto differential reflector 1545a and towards the light collection area, i.e. end 1555 of integrating rod 1550. In apparatus 1500, first collection optics comprises lens 1565 which receives and reduces divergence of light beams output from light collecting unit 1505b, and lens 1560 which receives the output light beams 1580 from lens 1565 and converges the output light beams 1580 towards differential reflector 1545a and the light collection area, i.e. end 1555 of integrating rod 1550.

Moreover, apparatus 1500 also comprises a second relay optics configured to receive light beams 505c from light collecting unit 1505c and direct light beams 505c through support aperture 1525c and reflector aperture 1535b, and onto differential reflector 1545b and towards lens 1565 of the first relay optics. In apparatus 1500, second relay optics comprises lens 1575 which receives and reduces the divergence of light beams 505c output from light collecting unit 1505c, and lens 1570 which receives the light beams 505c from lens 1575 and directs the light beams 505c through differential reflector 1545b and towards lens 1565 of the first relay optics.

The first relay optics, in turn, receives the combination of light beams 505c (collected and combined by light collecting unit 1505c) and light beams 505b (collected and combined by light collecting unit 1505b) in the form of combined output light beams 1580, and as discussed above, directs combined output light beams 1580 towards end 1555 of rod 1550. The light collection area, i.e. end 1555, receives a combined output light beam 1585, which is a combination of light beams 505a collected by light collecting unit 1505a and combined output light beams 1580 collected by light collecting units 1505b and 1505c and directed towards end 1555 by the combination of the first and second relay optics.

In other words, the second relay optics directs light beams 505c through support aperture 1525c and reflector aperture 1535b, and towards differential reflector 1545b and the first relay optics. The first relay optics, in turn, directs both light beams 505c and light beams 505b through support aperture 1525b and reflector aperture 1535a, and towards differential reflector 1545a and the light collection area, i.e. end 1555.

While apparatus 1500 is shown as comprising reflectors 1540c and 1545c, it is contemplated that in some implementations, apparatus 1500 may not have reflectors 1540c and 1545c, and light beams 505c can be reflected from reflector 1530c directly to the second relay optics.

According to an implementation of the present specification there is provided an apparatus for combining light, the apparatus comprising first, second, and third light collecting units 1505a, 1505b, and 1505c respectively, reflectors 1540a and 1540b, differential reflectors 1545a and 1545b, and first and second relay optics. First light collecting unit 1505a comprises first support 1510a having first face 1515a and second face 1520a opposite first face 1515a. First support 1510a defines first support aperture 1525a extending through first face 1515a and second face 1520a.

First light collecting unit 1505a also comprises first receiving banks 130 disposed on second face 1520a, the first receiving banks 130 being configured to receive first set of light sources 125a configured to emit first set of light beams 505a of a first color. First light collecting unit 1505a also comprises first reflector 1530a disposed proximate second face 1520a and facing second face 1520a. First reflector 1530a is configured to reflect first set of light beams 505a and to increase the convergence of first set of light beams 505a. First reflector 1530a also defines first reflector aperture 1535a.

Second light collecting unit 1505b comprises second support 1510b having first face 1515b and second face 1520b opposite first face 1515b. Second support 1510b defines second support aperture 1525b extending through first face 1515b and second face 1520b. Second support 1510b is disposed side-by-side with first support 1510a such that second face 1520a faces first face 1515b and first reflector 1530a is disposed between first support 1510a and second support 1510b.

Second light collecting unit 1505b also comprises second receiving bank 130 disposed on second face 1520b. Second receiving bank 130 is configured to receive a second set of light sources 125b configured to emit a second set of light beams 505b of a second color. Second light collecting unit 1505b also comprises second reflector 1530b disposed proximate second face 1520b and facing second face 1520b. Second reflector 1530b is configured to reflect second set of light beams 505b and to increase a corresponding convergence of the second set of light beams 505b. Second reflector 1530b defines second reflector aperture 1535b.

Third light collecting unit 1505c comprises third support 1510c having first face 1515c and second face 1520c opposite the first face 1515c. The third support 1510c defines third support aperture 1525c extending through the first face 1515c and the second face 1520c. Third support 1510c is disposed side-by-side with the second support 1510b such that the second face 1520b faces the first face 1515c and the second reflector 1530b is disposed between the second support 1510b and the third support 1510c.

Third light collecting unit 1505c also comprises third receiving bank 130 disposed on the second face 1520c, the third receiving bank 130 configured to receive third set of light sources 125c configured to emit third set of light beams 505c of a third color. Third light collecting unit 1505c also comprises third reflector 1530c disposed proximate the second face 1520c and facing the second face 1520c. The third reflector 1530c is configured to reflect the third set of light beams 505c and to increase a corresponding convergence of the third set of light beams 505c.

The apparatus also comprises a fourth reflector 1540a configured to reflect the first set of light beams 505a propagating from the first reflector 1530a onto first differential reflector 1545a. The first differential reflector 1545a is configured to reflect the first set of light beams 505a towards the light collection area.

The apparatus also comprises a fifth reflector 1540b configured to reflect the second set of light beams 505b propagating from the second reflector 1530b onto second differential reflector 1545b. The second differential reflector 1545b is configured to reflect the second set of light beams 505b towards the first relay optics configured to direct the second set of light beams 505b through the second support aperture 1525b, through the first reflector aperture 1535a, and towards the first differential reflector 1545a and the light collection area. The the first differential reflector 1545a is further configured to transmit the second set of light beams 505b.

The apparatus also comprises the second relay optics configured to direct the third set of light beams 505c propagating from the third reflector 1530c through the third support aperture 1525c, through the second reflector aperture 1535b, and towards the second differential reflector 1545b. The second differential reflector 1545b is further configured to transmit the third set of light beams 505c towards the first relay optics. Moreover, the first relay optics is further configured to direct the third set of light beams 505c through the second support aperture 1525b, the first reflector aperture 1535a, and towards the first differential reflector 1545a and the light collection area. The first differential reflector 1545a is further configured to transmit the third set of light beams 505c.

Referring now to the relay optics generally, it is contemplated that lens 1565 and lens 1575 can be positioned differently in relation to support 1510b and 1510c respectively than the positioning shown in Fig. 15. For example, lens 1565 can be to a side of support 1510b opposite first face 1515b (i.e. close to reflector 1530b), can be completely within support aperture 1525b, and/or can be to the side of support 1510b opposite second face 1520b (i.e. closer to reflector 1530a). Similar positioning is also contemplated for lens 1575 in relation to support 1510c. In addition, while in apparatus 1500 each of the first and second relay optics comprises two lenses, it is contemplated that in some implementations one or more of the first and second relay optics can comprise any number and/or combination of optical elements such as lenses, reflectors, and the like suitable for directing output light from one light combining unit to the next light combining unit.

Moreover, while in apparatus 1500 all three light collecting units 1505a, 1505b, and 1505c are shown as being centered about the optical axis (not shown in Fig. 15) lying along the length of integrating rod 1550, it is contemplated that the neighboring light collecting units can be positioned off of the optical axis provided suitable relay optics are used to direct light collected from one light collecting unit to the neighboring light collecting unit.

Referring to reflector 1530c, while in Fig. 15 reflector 1530c is shown as comprising reflector aperture 1535c, it is contemplated that in some implementations reflector 1530c may have no apertures since in apparatus 1500 no light passes through this reflector aperture. Moreover, while in apparatus 1500 the three light collecting units are similar, it is contemplated that in some implementations different types and/or numbers of light collecting units can be optically coupled to one another. Furthermore, it is contemplated that in some implementations, light collection optics (e.g. similar to collection optics 1405 shown in Fig. 4) can be used instead of and/or in addition to integrating rod 1550.

In all apparatuses described herein, it is contemplated that the apparatus need not include the light sources received in the receiving sites of the receiving banks. In addition, it is contemplated that the apparatuses described herein can include only some of the receiving sites of one or more of their receiving banks being filled with light sources, and the remaining receiving sites not being filled by operational light sources. The light sources referred to herein can comprise, but are not limited to, laser diodes and the like.

Moreover, regarding references herein to light beams being reflected and/or transmitted, it is contemplated that in practice there can be losses associated with reflection of light from a reflector and transmission of light through a component such as differential reflector. As such, reflection and transmission can include partial reflection and partial transmission.

The above-described implementations are intended to be exemplary and alterations and modifications may be effected thereto, by those of skill in the art, without departing from the scope of the invention which is defined solely by the claims appended hereto.

## Claims

1. An apparatus (100) for combining light, the apparatus comprising:
a support (105) having a first face (110) and a second face (115) opposite the first face, the support defining a support aperture (155) extending through the first face and the second face;
a first receiving bank (120) disposed on the first face, the first receiving bank configured to receive a first set of light sources (125) configured to emit a first set of light beams;
a first reflector (135) disposed to a side of the support opposite the second face, the first reflector facing the first face, the first reflector configured to reflect the first set of light beams towards the support aperture and to increase a convergence of the first set of light beams, the first reflector defining a reflector aperture (140);
**characterized in** comprising
a second receiving bank (130) disposed on the second face, the second receiving bank configured to receive a second set of light sources (125a) configured to emit a second set of light beams;
a second reflector (145) disposed to another side of the support opposite the first face, the second reflector facing the second face, the second reflector configured to reflect the second set of light beams towards the support aperture and to increase a corresponding convergence of the second set of light beams; and
a differential reflector (510) disposed in the support aperture, the differential reflector configured to reflect the first set of light beams in a direction away from the second reflector and to transmit the second set of light beams in a corresponding direction away from the second reflector.

2. The apparatus of claim 1, wherein the support comprises a circular disk and the support aperture is disposed at a center of the circular disk.

3. The apparatus of claim 2, further comprising a plurality of additional first receiving banks each configured to receive a corresponding set of light sources and a plurality of additional second receiving banks each configured to receive a corresponding set of light sources, the first receiving bank and the plurality of additional first receiving banks disposed radially on the first face, and the second receiving bank and the plurality of additional second receiving banks disposed radially on the second face.

4. The apparatus of claim 1, further comprising the first set of light sources received in the first receiving bank and the second set of light sources received in the second receiving bank.

5. The apparatus of claim 1, wherein one or more of:
the first reflector comprises a first curvature configured to increase the convergence of the first set of light beams; and
the second reflector comprises a second curvature configured to increase the corresponding convergence of the second set of light beams.

6. The apparatus of claim 5, wherein one or more of the first reflector and the second reflector comprises a parabolic reflector.

7. The apparatus of claim 1,
wherein:
the first set of light beams have a first wavelength range and the second set of light beams have a second wavelength range different from the first wavelength range; and
the differential reflector comprises a dichroic reflector configured to at least partially reflect the first set of light beams and to at least partially transmit the second set of light beams; and/or
wherein:
one or more of the first reflector and the second reflector comprises one or more of a stepped reflector and a faceted reflector.

8. The apparatus of claim 1, wherein the differential reflector comprises a reflective region configured to reflect the first set of light beams and a transmissive region configured to transmit the second set of light beams.

9. The apparatus of claim 8, wherein the reflective region and the transmissive region are shaped as concentric rings.

10. The apparatus of claim 1, further comprising a diffuser disposed to the side of the support opposite the second face, the diffuser configured to form a diffused light by intercepting and at least partially transmitting the first set of light beams reflected from the differential reflector and the second set of light beams transmitted through the differential reflector.

11. The apparatus of claim 10, further comprising a first lens disposed proximate the diffuser and to a corresponding side of the diffuser opposite the support, the first lens comprising a first lens face configured to receive at least a portion of the diffused light and a second lens face opposite the first lens face, the first lens configured to reduce a divergence of the portion of the diffused light and to form an output light propagating towards the reflector aperture.

12. The apparatus of claim 1, further comprising an integrating rod having an end disposed proximate the first face, the end positioned to receive the first set of light beams reflected from the differential reflector and the second set of light beams transmitted through the differential reflector.

13. The apparatus of claim 1,
wherein the second reflector comprises a beam splitter configured to reflect a first portion of the second set of light beams towards the support aperture and to transmit a second portion of the second set of light beams; and
further comprising a third reflector disposed to a corresponding side of the second reflector opposite the support, the third reflector facing the second face, the third reflector configured to reflect the second portion towards the support aperture and to increase a corresponding convergence of the second portion.

14. The apparatus of claim 1, further comprising
a beam splitter positioned to intercept the second set of light beams propagating from the second reflector towards the support aperture, the beam splitter configured to reflect a first portion of the second set of light beams and to transmit a second portion of the second set of light beams; and
a fourth reflector disposed to a corresponding side of the beam splitter opposite the support, the fourth reflector facing the second face, the fourth reflector configured to reflect the first portion towards the support aperture.

15. The apparatus of claim 1,
wherein one or more of:
the first receiving bank is disposed on a plane inclined relative to the first face; and
the second receiving bank is disposed on a corresponding plane inclined relative to the second face; and/or
wherein:
the support comprises a cold plate.

## Patentansprüche

1. Vorrichtung (100) zum Kombinieren von Licht, umfassend:
einen Träger (105) mit einer ersten Fläche (110) und einer zweiten Fläche (115) gegenüber der ersten Fläche, wobei der Träger eine Trägeröffnung (155) definiert, die durch die erste und die zweite Fläche verläuft;
eine erste Empfangsplatte (120), die auf der ersten Fläche ausgerichtet und konfiguriert ist, um einen ersten Lichtquellensatz (125) zu empfangen, der konfiguriert ist, um einen ersten Lichtstrahlensatz zu emittieren;
einen ersten Reflektor (135), der an einer Seite des Trägers gegenüber der zweiten Fläche angeordnet ist, wobei der erste Reflektor der ersten Fläche zugewandt und konfiguriert ist, um den ersten Lichtstrahlensatz in Richtung der Trägeröffnung zu reflektieren und eine Konvergenz des ersten Lichtstrahlensatzes zu erhöhen, wobei der erste Reflektor eine Reflektoröffnung (140) definiert, die **dadurch gekennzeichnet ist, dass** sie umfasst
eine zweite Empfangsplatte (130), die auf der zweiten Fläche angeordnet und konfiguriert ist, um einen zweiten Lichtquellensatz (125a) zu empfangen, der konfiguriert ist, um einen zweiten Satz aus Lichtstrahlen zu emittieren;
einen zweiten Reflektor (145), der an einer anderen Seite des Trägers gegenüber der ersten Fläche angeordnet und der zweiten Fläche zugewandt und konfiguriert ist, um den zweiten Lichtstrahlensatz in Richtung der Trägeröffnung zu reflektieren und eine entsprechende Konvergenz des zweiten Lichtstrahlensatzes zu erhöhen; und
einen Differenzreflektor (510), der in der Trägeröffnung angeordnet und konfiguriert ist, um den ersten Lichtstrahlensatz in einer Richtung weg vom zweiten Reflektor zu reflektieren und den zweiten Lichtstrahlensatz in entsprechender Richtung weg vom zweiten Reflektor zu übertragen.

2. Die Vorrichtung gemäß Anspruch 1, wobei der Träger eine runde Scheibe umfasst und die Trägeröffnung in der Mitte der runden Scheibe angeordnet ist.

3. Die Vorrichtung gemäß Anspruch 2, weiterhin umfassend mehrere zusätzliche erste Empfangsplatten, die jeweils konfiguriert sind, um einen entsprechenden Lichtquellensatz zu empfangen, und mehrere zusätzliche zweite Empfangsplatten, die jeweils konfiguriert sind, um einen entsprechenden Lichtquellensatz zu empfangen, wobei die erste Empfangsplatte und die mehreren zusätzlichen ersten Empfangsplatten radial auf der ersten Fläche und die zweite Empfangsplatte und die mehreren zusätzlichen zweiten Empfangsplatten radial auf der zweiten Fläche angeordnet sind.

4. Die Vorrichtung gemäß Anspruch 1, weiterhin umfassend den ersten Lichtquellensatz, der auf der ersten Empfangsplatte empfangen wird und den zweiten Lichtquellensatz, der auf der zweiten Empfangsplatte empfangen wird.

5. Die Vorrichtung gemäß Anspruch 1, wobei mindestens:
der erste Reflektor eine erste Wölbung umfasst, die konfiguriert ist, um die Konvergenz des ersten Lichtstrahlensatzes zu erhöhen; und
der zweite Reflektor eine zweite Wölbung umfasst, die konfiguriert ist, um die entsprechende Konvergenz des zweiten Lichtstrahlensatzes zu erhöhen.

6. Die Vorrichtung gemäß Anspruch 5, wobei mindestens der erste Reflektor und der zweite Reflektor einen Parabolreflektor umfassen.

7. Die Vorrichtung gemäß Anspruch 1, wobei:
der erste Lichtstrahlensatz einen ersten Wellenlängenbereich und der zweite Lichtstrahlensatz einen zweiten Wellenlängenbereich aufweist, der sich vom ersten Wellenlängenbereich unterscheidet; und
der Differenzreflektor einen Kaltlichtreflektor umfasst, der konfiguriert ist, um den ersten Lichtstrahlensatz wenigstens teilweise zu reflektieren und den zweiten Lichtstrahlensatz wenigstens teilweise zu übertragen; und/oder wobei: mindestens der erste Reflektor und der zweite Reflektor mindestens einen Stufenreflektor und einen Facettenreflektor umfassen.

8. Die Vorrichtung gemäß Anspruch 1, wobei der Differenzreflektor einen Reflexionsbereich umfasst, der konfiguriert ist, um den ersten Lichtstrahlensatz zu reflektieren, und einen durchlässigen Bereich, der konfiguriert ist, um den zweiten Lichtstrahlensatz zu übertragen.

9. Die Vorrichtung gemäß Anspruch 8, wobei der Reflexionsbereich und der durchlässige Bereich als konzentrische Ringe ausgebildet sind.

10. Die Vorrichtung gemäß Anspruch 1, die weiterhin einen Streukörper enthält, der an der Seite des Trägers gegenüber der zweiten Fläche angeordnet und so konfiguriert ist, dass er ein Streulicht ausbildet, indem er den ersten Lichtstrahlensatz, der aus dem Differenzreflektor reflektiert wird und den zweiten Lichtstrahlensatz, der durch den Differenzreflektor übertragen wird, auffängt und wenigstens teilweise überträgt.

11. Die Vorrichtung gemäß Anspruch 10, weiterhin umfassend eine erste Linse, die in der Nähe des Streukörpers und einer entsprechenden Seite des Streukörpers gegenüber dem Träger angeordnet ist, wobei die erste Linse eine erste Linsenfläche umfasst, die konfiguriert ist, um wenigstens einen Teil des Streulichts zu empfangen, und eine zweiten Linsenfläche gegenüber der ersten Linsenfläche, wobei die erste Linse konfiguriert ist, eine Divergenz des Anteils des Streulichts zu vermindern und ein Ausgabelicht auszugeben, das in Richtung der Reflektoröffnung weitergeleitet wird.

12. Die Vorrichtung gemäß Anspruch 1, weiterhin umfassend einen Integratorstab, dessen eines Ende in der Nähe der ersten Fläche angeordnet und so positioniert ist, dass es den ersten Lichtstrahlensatz empfängt, der aus dem Differenzreflektor reflektiert wird, sowie den zweiten Lichtstrahlensatz, der durch den Differenzreflektor übertragen wird.

13. Die Vorrichtung gemäß Anspruch 1, wobei der zweite Reflektor einen Strahlteiler umfasst, der konfiguriert ist, um den ersten Anteil des zweiten Lichtstrahlensatzes in Richtung der Trägeröffnung zu reflektieren und einen zweiten Anteil des zweiten Lichtstrahlensatzes zu übertragen,
weiterhin umfassend einen dritten Reflektor, der an einer entsprechenden Seite des zweiten Reflektors gegenüber dem Träger angeordnet ist, wobei der dritte Reflektor der zweiten Seite zugewandt und so konfiguriert ist, dass er den zweiten Anteil in Richtung der Trägeröffnung reflektiert und eine entsprechende Konvergenz des zweiten Anteils erhöht.

14. Die Vorrichtung gemäß Anspruch 1, weiterhin umfassend einen Strahlteiler, der so positioniert ist, dass er den zweiten Lichtstrahlensatz auffängt, der aus dem zweiten Reflektor in Richtung der Trägeröffnung weitergeleitet wird, und so konfiguriert ist, dass er einen ersten Anteil des zweiten Lichtstrahlensatzes reflektiert und einen zweiten Anteil des zweiten Lichtstrahlensatzes überträgt; sowie einen vierten Reflektor, der an einer entsprechenden Seite des Strahlteilers gegenüber dem Träger angeordnet und der zweiten Fläche zugewandt und so konfiguriert ist, dass er den ersten Anteil in Richtung der Trägeröffnung reflektiert.

15. Die Vorrichtung gemäß Anspruch 1, wobei mindestens:
die erste Empfangsplatte auf einer Ebene angeordnet ist, die zur ersten Fläche geneigt ist; und
die zweite Empfangsplatte auf einer entsprechenden Ebene angeordnet ist, die zur zweiten Fläche geneigt ist; und/oder wobei:
der Träger eine Kühlplatte umfasst.

## Revendications

1. Appareil (100) de combinaison de lumière, l'appareil comprenant :
un support (105) ayant une première face (110) et une seconde face (115) opposée à la première face, le support définissant une ouverture de support (155) s'étendant à travers la première face et la seconde face ;
un premier banc de réception (120) disposé sur la première face, le premier banc de réception étant configuré pour recevoir un premier ensemble de sources de lumière (125) configuré pour émettre un premier ensemble de faisceaux de lumière ;
un premier réflecteur (135) disposé sur un côté du support opposé à la seconde face, le premier réflecteur étant dirigé vers la première face, le premier réflecteur étant configuré pour réfléchir le premier ensemble de faisceaux de lumière vers l'ouverture de support et augmenter une convergence du premier ensemble de faisceaux de lumière, le premier réflecteur définissant une ouverture de réflecteur (140) ;
**caractérisé par le fait qu'**il comprend
un second banc de réception (130) disposé sur la seconde face, le second banc de réception étant configuré pour recevoir un second ensemble de sources de lumière (125a) configuré pour émettre un second ensemble de faisceaux de lumière ;
un deuxième réflecteur (145) disposé sur un autre côté du support opposé à la première face, le deuxième réflecteur étant dirigé vers la seconde face, le deuxième réflecteur étant configuré pour réfléchir le second ensemble de faisceaux de lumière vers l'ouverture de support et augmenter une convergence correspondante du second ensemble de faisceaux de lumière ; et
un réflecteur différentiel (510) disposé dans l'ouverture de support, le réflecteur différentiel étant configuré pour réfléchir le premier ensemble de faisceaux de lumière dans une direction à l'écart du deuxième réflecteur et transmettre le second ensemble de faisceaux de lumière dans une direction correspondante à l'écart du deuxième réflecteur.

2. Appareil selon la revendication 1, dans lequel le support comprend un disque circulaire et l'ouverture de support est disposée à un centre du disque circulaire.

3. Appareil selon la revendication 2, comprenant en outre une pluralité de premiers bancs de réception supplémentaires chacun configuré pour recevoir un ensemble correspondant de sources de lumière et une pluralité de seconds bancs de réception supplémentaires chacun configuré pour recevoir un ensemble correspondant de sources de lumière, le premier banc de réception et la pluralité de premiers bancs de réception supplémentaires étant disposés radialement sur la première face, et le second banc de réception et la pluralité de seconds bancs de réception supplémentaires étant disposés radialement sur la seconde face.

4. Appareil selon la revendication 1, comprenant en outre le premier ensemble de sources de lumière reçu dans le premier banc de réception et le second ensemble de sources de lumière reçu dans le second banc de réception.

5. Appareil selon la revendication 1, dans lequel un ou plusieurs parmi :
le premier réflecteur comprend une première courbure configurée pour augmenter la convergence du premier ensemble de faisceaux de lumière ; et
le deuxième réflecteur comprend une seconde courbure configurée pour augmenter la convergence correspondante du second ensemble de faisceaux de lumière.

6. Appareil selon la revendication 5, dans lequel au moins un parmi le premier réflecteur et le deuxième réflecteur comprend un réflecteur parabolique.

7. Appareil selon la revendication 1, dans lequel :
le premier ensemble de faisceaux de lumière a une première plage de longueurs d'onde et le second ensemble de faisceaux de lumière a une seconde plage de longueurs d'onde différente de la première plage de longueurs d'onde ; et
le réflecteur différentiel comprend un réflecteur dichroïque configuré pour réfléchir au moins partiellement le premier ensemble de faisceaux de lumière et transmettre au moins partiellement le second ensemble de faisceaux de lumière ; et/ou
au moins un parmi le premier réflecteur et le deuxième réflecteur comprend un réflecteur à étages et un réflecteur à facettes.

8. Appareil selon la revendication 1, dans lequel le réflecteur différentiel comprend une région de réflexion configurée pour réfléchir le premier ensemble de faisceaux de lumière et une région de transmission configurée pour transmettre le second ensemble de faisceaux de lumière.

9. Appareil selon la revendication 8, dans lequel la région de réflexion et la région de transmission sont sous la forme d'anneaux concentriques.

10. Appareil selon la revendication 1, comprenant en outre un diffuseur disposé sur le côté du support opposé à la seconde face, le diffuseur étant configuré pour former une lumière diffuse en interceptant et en transmettant au moins partiellement le premier ensemble de faisceaux de lumière réfléchi par le réflecteur différentiel et le second ensemble de faisceaux de lumière transmis par le réflecteur différentiel.

11. Appareil selon la revendication 10, comprenant en outre une première lentille disposée à proximité du diffuseur et sur un côté correspondant du diffuseur opposé au support, la première lentille comprenant une première face de lentille configurée pour recevoir au moins une partie de la lumière diffuse et une seconde face de lentille opposée à la première face de lentille, la première lentille étant configurée pour réduire une divergence de la partie de la lumière diffuse et former une lumière de sortie se propageant vers l'ouverture de réflecteur.

12. Appareil selon la revendication 1, comprenant en outre une tige d'intégration ayant une extrémité disposée à proximité de la première face, l'extrémité étant positionnée pour recevoir le premier ensemble de faisceaux de lumière réfléchi par le réflecteur différentiel et le second ensemble de faisceaux de lumière transmis par le réflecteur différentiel.

13. Appareil selon la revendication 1,
dans lequel le deuxième réflecteur comprend un diviseur de faisceau configuré pour réfléchir une première partie du second ensemble de faisceaux de lumière vers l'ouverture de support et transmettre une seconde partie du second ensemble de faisceaux de lumière ; et
comprenant en outre un troisième réflecteur disposé sur un côté correspondant du deuxième réflecteur opposé au support, le troisième réflecteur étant dirigé vers la seconde face, le troisième réflecteur étant configuré pour réfléchir la seconde partie vers l'ouverture de support et augmenter une convergence correspondante de la seconde partie.

14. Appareil selon la revendication 1, comprenant en outre
un diviseur de faisceau positionné pour intercepter le second ensemble de faisceaux de lumière se propageant du deuxième réflecteur vers l'ouverture de support, le diviseur de faisceau étant configuré pour réfléchir une première partie du second ensemble de faisceaux de lumière et transmettre une seconde partie du second ensemble de faisceaux de lumière ; et
un quatrième réflecteur disposé sur un côté correspondant du diviseur de faisceau opposé au support, le quatrième réflecteur étant dirigé vers la seconde face, le quatrième réflecteur étant configuré pour réfléchir la première partie vers l'ouverture de support.

15. Appareil selon la revendication 1, dans lequel :
le premier banc de réception est disposé sur un plan incliné par rapport à la première face ; et/ou
le second banc de réception est disposé sur un plan correspondant incliné par rapport à la seconde face ; et/ou
le support comprenant une plaque froide.
